(19) Europäisches Patentamt
European Patent Office
Office européen des brevets

(11) **EP 4 172 103 B1**

(12) **EUROPÄISCHE PATENTSCHRIFT**

(45) Veröffentlichungstag und Bekanntmachung des Hinweises auf die Patenterteilung:
**08.04.2026   Patentblatt 2026/15**

(21) Anmeldenummer: **21739040.0**

(22) Anmeldetag: **29.06.2021**

(51) Internationale Patentklassifikation (IPC):
**B81C 1/00** *(2006.01)*       **B23K 26/20** *(2014.01)*
**B23K 26/38** *(2014.01)*

(52) Gemeinsame Patentklassifikation (CPC):
**B81C 1/00269; B23K 26/206; B23K 26/38;**
**B81C 1/00317;** B23K 2101/36; B81B 2201/0214;
B81C 2203/0118; B81C 2203/037

(86) Internationale Anmeldenummer:
**PCT/EP2021/067877**

(87) Internationale Veröffentlichungsnummer:
**WO 2022/002957 (06.01.2022 Gazette 2022/01)**

(54) **HERMETISCH VERSCHLOSSENE UMHÄUSUNG UND VERFAHREN ZU DEREN HERSTELLUNG**

HERMETICALLY SEALED ENCLOSURE AND METHOD FOR THE PRODUCTION THEREOF

ENCEINTE HERMÉTIQUEMENT SCELLÉE ET SON PROCÉDÉ DE PRODUCTION

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **30.06.2020   DE 102020117194**

(43) Veröffentlichungstag der Anmeldung:
**03.05.2023   Patentblatt 2023/18**

(73) Patentinhaber: **SCHOTT AG**
**55122 Mainz (DE)**

(72) Erfinder:
• **MÄÄTTÄNEN, Antti**
**33710 Tampere (FI)**
• **THOMAS, Jens Ulrich**
**55128 Mainz (DE)**

(74) Vertreter: **Blumbach · Zinngrebe Patentanwälte
PartG mbB
Alexandrastraße 5
65187 Wiesbaden (DE)**

(56) Entgegenhaltungen:
**EP-A1- 2 219 215     DE-A1- 10 235 372**

• **WITTE R ET AL: "Laser joining of glass with silicon", PROCEEDINGS OF SPIE, IEEE, US, vol. 4637, 21 January 2002 (2002-01-21), pages 487 - 495, XP001156588, ISBN: 978-1-62841-730-2, DOI: 10.1117/12.470657**

## Beschreibung

Gebiet der Erfindung

Die vorliegende Erfindung betrifft eine hermetisch verschlossene Umhäusung, eine Substratanordnung sowie ein Verfahren zum Bereitstellen einer hermetisch dichten Umhäusung.

Hintergrund und allgemeine Beschreibung der Erfindung

Hermetisch verschlossene Umhäusungen sind beispielsweise dafür vorgesehen, ein Bauteil oder Bauteile im Inneren der Umhäusung vor widrigen Umweltbedingungen zu schützen. So können sensible Elektronik, Schaltkreise oder beispielsweise Sensoren geschützt werden, die im Inneren der Umhäusung angeordnet sind. Auf diese Weise können Sensoren oder medizinische Implantate, beispielsweise im Bereich des Herzens, in der Retina oder für Bioprozessoren aufgebaut und eingesetzt werden. Diese können beispielsweise auch als MEMS (Mikro-Elektro-Mechanische Systeme), Barometer, Blutgassensor, Glukosesensor, usw. eingesetzt sein. Es sind Bioprozessoren bekannt, welche aus Titan angefertigt und eingesetzt werden.

Weitere Felder für den Einsatz einer erfindungsgemäßen Umhäusung können auch in Elektronikanwendungen gefunden werden, wie eine Hülle für ein Smartphone, im Bereich von Virtual Reality-Brillen und ähnlichem Gerät. Eine erfindungsgemäße Umhäusung kann auch für die Herstellung von Flusszellen, beispielsweise im Rahmen der Elektromobilität, zum Einsatz kommen. Aber auch in der Luft- und Raumfahrt, in Hochtemperaturanwendungen, wie auch im Bereich der Mikrooptik sind erfindungsgemäße Umhäusungen einsetzbar.

Da an eine Umhäusung die vorgenannten Anforderungen zum Schutz der darin beherbergten Elektronik gestellt sind, scheiden bislang bestimmte Anwendungsfelder für den Einsatz einer erfindungsgemäßen Umhäusung aus, worunter Anforderungen fallen, für die eine besonders dünne Umhäusung oder jedenfalls eine dünne Seite der Umhäusung notwendig wäre. Hierunter kann beispielsweise ein Fingerabdrucksensor, Kontaktlinsen mit variablem Fokus, neuralgische Drucksensoren für den Gebrauch innerhalb eines Körpers, wie beispielsweise die Messung des Gehirninnendrucks oder die ultradünne Einhäusung von Bildsensoren gesehen werden. Auch für diese Anwendungsbereiche kann es vorteilhaft sein, die Elektronik entsprechend gegen die widrigen Umwelteinflüsse zu schützen. Ein insbesondere optischer Austausch mit dem Innenbereich der Umhäusung kann hierbei in vorteilhafter Weise gewährleistet sein. Hierfür kann die Umhäusung zumindest teilweise - d. h. zumindest bereichsweise und/oder zumindest für einen Wellenbereich - transparent eingerichtet sein. Diese Transparenz erlaubt des Weiteren beispielsweise Kommunikationsverfahren, Daten oder Energieübertragung, Messungen von und mit der in der Kavität angeordneten Elektronik bzw. Sensor. Es können insbesondere optische Kommunikationsverfahren bzw. optische Daten oder Energieübertragung ermöglicht sein.

Es ist allerdings kompliziert bzw. ggf. sogar unmöglich, ein dünnes Substrat als solches herzunehmen und dieses auf eine Umhäusung aufzusetzen. Dünne Substrate wölben sich bei der Herstellung eines Verbunds mit weiteren Substratschichten auf. Die physikalischen Eigenschaften wie thermische Leitfähigkeit des dünnen Substrats können sich dabei ebenfalls verändern. Darüber hinaus können dünne Substrate hohe Eigenspannungen aufweisen, die sie für die Herstellung einer Umhäusung ungeeignet werden lassen. Fügeverfahren mit Lasern können bei dünnen Substraten nicht angewendet werden, da beispielsweise Material verbrannt oder abgetragen wird, wenn mit dem Laser zu dicht an die Oberfläche des dünnen Substrats gezielt wird. Damit ist es schwierig oder sogar unmöglich, dünne Substrate heranzuziehen zur Herstellung einer Umhäusung, welche zugleich besonders gut hermetisch abgedichtet ist und/oder ohne zusätzliche Verbindungsmaterialien verbunden werden kann.

Es ist grundsätzlich bekannt, mehrere Teile zusammenzufügen und diese Teile so anzuordnen, dass in einem Zwischenraum ein Aufnahmebereich entsteht, in welchem Komponenten beherbergt werden können. Beispielsweise zeigt die Europäische Patentschrift EP 3 012 059 B1 ein Verfahren zur Herstellung eines transparenten Teils zum Schützen eines optischen Bauteils. Es wird dabei ein neuartiges Laserverfahren eingesetzt.

Die europäische Anmeldung EP 2 219 215 A1 betrifft ein Halbleiterbauelement und ein Verfahren zu dessen Herstellung. Dabei werden ein transparentes und ein zweites Substrat miteinander verbunden, wobei auf dem zweiten Substrat ein funktionelles Element angeordnet ist. Dabei wird allerdings kein dünnes transparentes Substrat verwendet, und es kommt auch kein Laserverfahren zum Einsatz.

Die vorliegende Erfindung kann darin gesehen werden, bekannte Umhäusungen zu verbessern und insbesondere den Austausch mit einem Innenbereich der Umhäusung zu verbessern. Insbesondere soll der optische Austausch mit dem Innenraum der Umhäusung oder aber eine Sensibilität, wie beispielsweise eine Drucksensibilität, für die äußere Umgebung der Umhäusung verbessert werden. Gegebenenfalls erlaubt die erfindungsgemäße Umhäusung den Einsatz von kostengünstigeren Bauteilen und/oder eine sensitivere Messung von Umgebungsdaten. Dabei sind die Umhäusungen der vorliegenden Erfindung so zuverlässig und langlebig wie bekannte Umhäusungen.

Eine erfindungsgemäße hermetisch verschlossene Umhäusung umfasst zumindest ein flächig ausgedehntes Abdecksubstrat, wobei das Abdecksubstrat eine äußere Flachseite und eine umlaufende Schmalseite aufweist. Mit anderen Worten weist das Abdecksubstrat eine Außenseite auf, die zur Umgebung hin ausgerichtet ist und welche im Wesentlichen flächig bzw. flach ausgebildet ist. An die äußere Flachseite angrenzend und typischerweise in einem rechten Winkel zu der äußeren Flachseite orientiert, beispielsweise um den Rand der äußeren Flachseite umlaufend ausgestaltet, ist eine umlaufende Schmalseite. In einem Beispiel ist das Abdecksubstrat als Platte oder Quader beschreibbar, aufweisend zwei großflächige Seiten sowie vier zwischen den großflächigen Seiten angeordnete kleinere Seiten, die insbesondere senkrecht auf die beiden großflächigen Seiten stehen und an die großflächigen Seiten angrenzen. Dann bilden die vier kleineren Seiten gemeinsam die umlaufende Schmalseite und die Oberseite die äußere Flachseite des Abdecksubstrats. Die Oberseite weist dabei typischerweise eine größere Oberfläche auf als die kleineren Seiten der umlaufenden Schmalseite zusammen.

Die hermetisch verschlossene Umhäusung weist ferner ein zu dem Abdecksubstrat benachbart angeordnetes und mit dem flächig ausgedehnten Abdecksubstrat in direktem Kontakt stehendes zweites Substrat auf. Das zweite Substrat bildet zusammen mit dem Abdecksubstrat zumindest einen Teil der Umhäusung. Bevorzugt sind die beiden Substrate übereinander angeordnet, d. h. gestapelt. Beispielsweise bilden die Substrate zusammen einen Substratstapel aus. Die Orientierung oberhalb bzw. unterhalb ist dabei lediglich beschreibend gemeint, da selbstverständlich die Substrate jede Orientierung im Raum annehmen können und auch eine Nebeneinanderanordnung nicht den Schutzbereich verlassen soll. Die beiden Substrate sind typischerweise mit einer größeren Seite ihrer Ausdehnung aneinander anliegend angeordnet.

Die Umhäusung weist ferner einen von der Umhäusung umschlossenen Funktionsbereich auf, welcher insbesondere zwischen dem Abdecksubstrat und dem zweiten Substrat angeordnet ist. Der Funktionsbereich ist beispielsweise eine Kavität oder eine aktive Schicht.

Ferner weist die Umhäusung eine Laserbondlinie auf, mittels welcher das Abdecksubstrat mit dem zu dem Abdecksubstrat benachbart angeordnetem Substrat direkt hermetisch dicht gefügt ist. Eine Laserbondlinie weist typischerweise eine Höhe HL senkrecht zu seiner Verbindungsebene auf. In bevorzugter Weise reicht die Laserbondlinie mit der Höhe HL in das Material des oberhalb der Laserbondlinie angeordneten Substrats hinein. Gegenüberliegend reicht die Laserbondlinie in das Material des unter der Laserbondlinie liegenden Substrats hinein. Beispielsweise wird das Abdecksubstrat mit dem zweiten Substrat schmelzend und direkt miteinander gefügt, ohne dass beispielsweise Vermittler oder Kleber eingesetzt werden müssen. Die Laserbondlinie kann auch in physikalischer Hinsicht in eines der beiden zu fügenden Substrate gesetzt werden, also der Zielpunkt des Lasers in einem der beiden Substrate liegen, wobei sich die Laserbondlinie stets in die beiden zu fügenden Substrate gemeinsam hinein erstreckt. Bei dem Fügeschritt bzw. in der Laserbondlinie vermischt sich schmelzend Material des einen Substrats mit Material des anderen Substrats zur Herstellung des festen und nicht lösbaren hermetischen Verbunds zwischen dem einen Substrat und dem anderen Substrat.

Wenn die Umhäusung nur aus dem Abdecksubstrat und dem zweiten Substrat besteht, um die Umhäusung als Ganzes zu bilden, so ist das Abdecksubstrat mit dem zweiten Substrat direkt miteinander gefügt und die Umhäusung weist eine Laserbondlinie auf. Die Umhäusung weist dann ferner eine Verbindungsebene auf bzw. einen Fügebereich, in welchem Substrate miteinander gefügt sind. In einem weiteren Beispiel kann die Umhäusung aus drei Substraten gestapelt aufgebaut sein, wobei das Abdecksubstrat mit dem zweiten Substrat direkt gefügt ist und das zweite Substrat mit einem Basissubstrat, welches gleichermaßen einen Boden der Umhäusung bildet. In diesem Beispiel weist die Umhäusung zwei Kontaktzonen bzw. zwei Fügebereiche auf, in denen die Umhäusung gefügt ist.

Die Umhäusung weist das Abdecksubstrat als transparentes Dünnschichtsubstrat auf, wobei das Abdecksubstrat eine Dicke von weniger als 200 μm aufweist. Ein solches Dünnschichtsubstrat weist alle Vorteile auf, die auch eine herkömmliche Umhäusung bereitzustellen vermag, nämlich insbesondere den hermetischen Verschluss der Innenseite der Umhäusung von der Umgebung wie auch die chemische Inertheit der Umhäusung, die insbesondere für einen intrakorporalen Einsatz vorteilhaft ist. Überdies eröffnet der Einsatz einer erfindungsgemäßen Umhäusung aber auch Anwendungsbereiche dort, wo herkömmliche Umhäusungen bislang nicht eingesetzt werden konnten. Beispielsweise kann ein Drucksensor empfindlicher ausgestaltet werden und besonders genaue optische Datenübertragungen, wie beispielsweise für einen Fingerabdrucksensor notwendig, können realisiert werden.

Eine Umhäusung bildet typischerweise eine Kavität, d. h. einen Hohlraum auf einer Innenseite der Umhäusung. Beispielsweise weist die Kavität einen seitlich umlaufenden Rand, eine Unterseite sowie eine Oberseite auf, an welcher die Kavität von der Umhäusung umschlossen ist. Mit anderen Worten ist die Kavität von der Umhäusung allseits umschlossen, so dass die Innenseite der Umhäusung zugleich die Umrandung der Kavität bildet, sofern in der Umhäusung genau eine Kavität vorhanden ist. Im Falle von zwei oder mehr Kavitäten in der Umhäusung sind die zwei oder mehreren Kavitäten gemeinsam von der Umhäusung umschlossen.

Im Sinne dieser Anmeldung ist Unterseite bzw. Oberseite ein geometrisches Konstrukt, die im Hinblick auf die endgültige Lage der Umhäusung auch jede andere Seite sein kann. Es kann alternativ die Oberseite als eine erste Seite beschrieben werden, die Unterseite als eine zweite, der ersten Seite gegenüberliegende Seite und der Rand als Zwischenbereich zwischen erster und zweiter Seite, wobei der Rand typischerweise im Wesentlichen senkrecht zur ersten und/oder zweiten Seite steht. Der seitlich umlaufende Rand verbindet typischerweise die erste Seite mit der zweiten Seite.

Ist die Kavität als Beherbergungskavität ausgebildet, ist darin beispielsweise ein Beherbergungsbauteil angeordnet. Dies können elektronische Schaltkreise, Sensoren oder MEMS (mikroelektromechanisches System) oder auch MOEMS (mikrooptoelektromechanisches System) sein.

Die Substrate werden direkt aneinander oder aufeinander angeordnet. Das bedeutet, dass die zumindest zwei Substrate so aneinander angeordnet bzw. angebracht werden, dass sie flächig aneinander zu liegen kommen, ohne dass andere Materialien oder Schichten zwischen den zumindest zwei Substraten vorhanden oder eingefügt sind. Möglicherweise sind aus technischen Gründen geringste Gaseinschlüsse oder Unreinheiten, wie Staubpartikel zwischen den Substratschichten, nicht zu vermeiden. Dies kann sich auch aus eventuellen Unebenheiten auch im Mikrobereich zwischen den Substratschichten oder an den Oberflächen der Substratschichten ergeben. Es ist bevorzugt, wenn ein solcherart möglicherweise vorhandener Abstand bzw. Spalt zwischen den Substraten kleiner oder gleich 5 $\mu$m aufweist, bevorzugt kleiner oder gleich 1 $\mu$m. In weiter bevorzugter Ausgestaltung ist die vom Laser erzeugte Fügezone bzw. Laserbondlinie in einer Dicke zwischen 10 - 50 $\mu$m vorhanden. Die Laserbondlinie stellt somit eine hermetische Versiegelung sicher, da er den möglicherweise auftretenden Abstand zwischen den beiden Substraten sicher überbrückt.

Eine der oder die Laserbondlinie kann den Funktionsbereich in einem Abstand DF umlaufend umschließen. Der Abstand DF umlaufend um den Funktionsbereich kann konstant sein, so dass die Laserbondlinie allseits im ungefähr gleichen Abstand um den Funktionsbereich herum angeordnet ist. Der Abstand DF kann je nach Anwendungsfall auch variieren, was gegebenenfalls produktionstechnisch günstiger sein kann, wenn beispielsweise eine Mehrzahl von Umhäusungen in einem gemeinsamen Arbeitsschritt gefügt wird, oder wenn der Funktionsbereich eine runde oder beliebige Form aufweist und die Laserbondlinie in gerader Linie gezogen wird. Auch in dem Fall, dass die Kavität optische Eigenschaften aufweist, beispielsweise in Form einer Linse, wie einer Sammellinse, ausgeformt ist, kann die Laserbondlinie um die Kavität herum ausgebildet sein und gegebenenfalls verschiedene Abstände zur Kavität aufweisen. Eine Umhäusung kann auch mehrere Kavitäten umfassen.

An dem Kontaktbereich zwischen den zumindest zwei Substraten kann die Umhäusung bzw. der Kontaktbereich optisch transparent ausgebildet sein oder auch im sichtbaren Wellenlängenbereich opak. Lediglich dasjenige Substrat, durch welches der Laser für den Fügeprozess durchtritt, um die Laserbondlinie zu bilden, weist zumindest ein spektrales Fenster auf, so dass zumindest die Wellenlänge des eingesetzten Lasers durch das Substrat zumindest teilweise oder zumindest bereichsweise hindurchtreten kann. Der Kontaktbereich ist daher so hergerichtet, dass mittels eines Laserfügeverfahrens dort eine Energiedeposition eingebracht werden kann. Dort wird der Laser also zumindest teilweise absorbiert. Dies kann derart lokal durchgeführt werden, dass bei dem Laserfügeverfahren von einem Kalt-Fügeverfahren gesprochen werden kann. Die zum Fügen bereitgestellte Wärmeenergie wird also konzentriert auf den Bereich der Laserbondlinie eingebracht und diffundiert nur vergleichsweise langsam in das übrige Material der Umhäusung, so dass insbesondere kein signifikanter Temperaturanstieg im Funktionsbereich auftritt.

Lokal im Bereich der Laserbondlinie wird dabei vermittels des Lasers Material der beiden Substrate zumindest angeschmolzen, so dass sich die zumindest zwei Substrate lokal verbinden. Der Fachmann kann hierfür beispielsweise auf die EP 3 012 059 B1 zurückgreifen.

Das Abdecksubstrat kann eine Dicke von weniger als 170 $\mu$m aufweisen. Bevorzugt ist die Dicke des Abdecksubstrats 150 $\mu$m oder weniger, weiter bevorzugt 125 $\mu$m oder weniger. Das Abdecksubstrat kann ferner eine Dicke von 10 $\mu$m oder mehr, bevorzugt 20 $\mu$m oder mehr aufweisen. Mit anderen Worten ist bevorzugt die Dicke des Abdecksubstrats in einem Bereich von 10 - 170 $\mu$m, beispielsweise bevorzugt in einem Bereich von 20 - 150 $\mu$m.

Eine vorteilhafte Dicke für das Abdecksubstrat 3, wenn die Umhäusung als Drucksensor eingesetzt wird, kann im Bereich 100 $\mu$m bis 150 $\mu$m liegen. Grundsätzlich kann mit einer dünneren Substratdicke des Abdecksubstrats 3 eine höhere Sensitivität insbesondere für optische Messungen oder Druckmessungen (bspw. auch für Druckmessungen, die auf Änderung der optischen Eigenschaft des Abdecksubstrats 3 basieren) erreicht werden. Allerdings ist eine untere Grenze der Dicke des Abdecksubstrats 3 insbesondere für einen Teil 3a, der eine Kavität 2 überspannt, durch spontanes Materialversagen oder mit abnehmender Materialdicke sinkende Widerstandsfähigkeit gegenüber Stoß- oder Druckbelastung festzustellen. Hieraus hat sich ein gut zu verwendender Bereich für die vorliegenden Anwendungen im Bereich von 100 $\mu$m bis 150 $\mu$m ergeben.

Die Dicke des Abdecksubstrats 3 kann ferner auch von der Fläche bzw. der Größe der zu überspannenden Kavität 2 abhängig sein. Beispielsweise weist die Kavität eine Fläche auf, die von dem Abdecksubstrat überspannt wird. Diese Fläche der Kavität bzw. des Funktionsbereichs kann beispielsweise im Bereich $1 \times 10^{-4}$ bis $1 \times 10^{-8}$ m$^2$ liegen, bevorzugt $1 \times 10^{-5}$ bis $1 \times 10^{-7}$., weiter bevorzugt $1 \times 10^{-6} \pm$ eine Größenordnung betragen. Mit anderen Worten ist die Fläche der Kavität bzw. des Funktionsbereichs $1 \times 10^{-4}$ m$^2$ oder kleiner, bevorzugt $1 \times 10^{-5}$ oder kleiner, weiter bevorzugt im Bereich $1 \times 10^{-6}$ oder kleiner. Die Fläche der Kavität bzw. des Funktionsbereichs ist des Weiteren $1 \times 10^{8}$ oder größer, bevorzugt $1 \times 10^{-7}$ oder größer, weiter bevorzugt im Bereich von $1 \times 10^{-6}$ oder größer.

Ein Abdecksubstrat für eine Umhäusung kann beispielsweise ein Verhältnis von Dicke des Abdecksubstrats 3 zu Fläche des Funktionsbereichs 18 bzw. Kavität 2 aufweisen, wobei das Verhältnis im Bereich 0,5 bis 20.000 liegt, bevorzugt im Bereich 1 bis 10.000, weiter bevorzugt 5 bis 1.000, noch weiter bevorzugt 10 bis 100. Kann der Funktionsbereich aufliegend überdeckt werden, also wobei der Teil 3a nicht freitragend ausgeführt ist, so kann das Verhältnis von Dicke des Abdecksubstrats 3 zu Fläche des Funktionsbereichs 18 besonders klein ausfallen, da eine Durchbiegung nicht zu erwarten ist.

Die Laserbondlinie weist eine Breite B in eine Richtung parallel zur flächigen Erstreckungsrichtung des Abdecksubstrats auf. Insbesondere ist die Breite W gemessen an der Oberfläche des Abdecksubstrats, das ist die äußere Flachseite.

In dem mit dem Substrat verbundenen Zustand weist das Abdecksubstrat in überraschender und nicht vorhersehbarer Weise eine erhöhte Scherfestigkeit auf. So ist es bevorzugt, wenn die Scherfestigkeit des Abdecksubstrats gerade dadurch erhöht ist, dass es über die erfindungsgemäß gestaltete Laserbondlinie mit dem zweiten Substrat verbunden ist. Mit anderen Worten ist die erhöhte Scherfestigkeit gerade dadurch erzielt, dass das Abdecksubstrat zunächst in dickerer Form vorliegt und mittels des Lasers an das benachbarte Substrat in der dickeren Form gefügt wird. Die sich hierdurch ausbildende Laserbondlinie unterscheidet sich von einer solchen Laserbondlinie, die erhalten würde, wenn das Abdecksubstrat bereits als Dünnschichtsubstrat bereitgestellt werden würde und mittels des Lasers gefügt werden solle. Dann ist nämlich der Eintrag der Laserbondlinie in das Material des Abdecksubstrats (d.h. somit auch der Zielpunkt des Lasers) so dicht an der äußeren Flachseite, dass die äußere Flachseite vom Laser beschädigt oder verändert wird und gerade nicht die Verbesserung des Abdecksubstrats erreicht wird.

Die Laserbondlinie bildet insbesondere dann einen Teil der Außenseite des Abdecksubstrats, indem beispielsweise das Abdecksubstrat als dickeres Substrat bereitgestellt und gefügt wird und anschließend die Dicke abgetragen wird, beispielsweise mittels eines abrasiven Verfahrens. Wenn die Laserbondlinie einen Teil der Außenseite des Abdecksubstrats bildet, oder mit anderen Worten wenn die Laserbondlinie bis in die Außenseite des Abdecksubstrats ragt, dann können Materialspannungen im Abdecksubstrat in besonders vorteilhafter Weise gesenkt bzw. entspannt werden. Beispielsweise kann die Stressreduzierung durch die vorteilhafte Kombination bei dem Materialabtrag, also z.B. dem Polieren der Oberfläche, eingebracht werden. Beispielsweise kann die im Material des Abdecksubstrats vorhandene Spannung durch das Laserfügen bzw. das Abtragen des Materials, ggf. der Kombination der beiden Schritte, um zumindest 15% gesenkt werden, vorteilhaft um zumindest 25%, weiter bevorzugt um zumindest 50% und ggf. sogar um 65% oder mehr gesenkt werden. Mit andere Worten ist das ausgedünnte Abdecksubstrat sogar stressärmer, als ein auf andere Weise, beispielsweise aufgeklebtes, Dünnschichtsubstrat. Dadurch kann das Abdecksubstrat formstabiler sein, und/oder es kann ein höheres Maß an Biegung tolerieren ohne zu brechen, ggf. kann es auch schlagfester sein.

Bevorzugt weist die Umhäusung an der äußeren Flachseite eine Beschichtungslage auf. Mit anderen Worten ist die äußere Flachseite beschichtet, beispielsweise um die optischen Eigenschaften zu verbessern.

Die äußere Flachseite kann einen Nanoaufdruck oder eine Nanoprägung erhalten. Ferner kann auf der äußeren Flachseite ein äußerer Funktionsbereich angeordnet sein. Beispielsweise für eine Beschichtungslage eingesetzt werden können AR-Coatings, Schutzbeschichtungen, bioaktive Filme, optische Filter, leitfähige Schichten, zum Beispiel aus ITO oder Gold. Da in vorteilhafter Weise die Beschichtung nach dem Fügeschritt aufgebracht werden kann, ist nicht notwendigerweise vorzusehen, dass die Beschichtungslage von dem Laser durchdringbar gestaltet sein muss.

Auch die innere Flachseite, das heißt die zu dem zweiten Substrat hin ausgerichtete Seite des ersten Substrats, kann eine Beschichtungslage aufweisen. Sofern diese innere Beschichtungslage vollflächig ausgebildet bzw. aufgetragen ist, kann diese im Bereich der Laserbondlinie Teil der Laserbondlinie werden. Die Beschichtungslage kann auch teilabdeckend ausgebildet sein und somit nur eine Teilfläche der inneren Flachseite abdecken. Ein Beispiel für die beidseitige Aufbringung je einer Beschichtungslage ist der zumindest teilweise oder bereichsweise Auftrag eines Antireflex-Coatings auf beiden Seiten des ersten Substrats.

Das Abdecksubstrat und/oder das zweite Substrat bzw. weitere Substrate können aus Wafern bestehen oder ausgeschnitten sein, beispielsweise aus Glas, Glaskeramik, Silizium, Saphir oder einer Kombination der vorgenannten Materialien umfassen. Das Material des zweiten Substrats kann sich von dem Material des Abdecksubstrats unterscheiden. Es ist besonders vorteilhaft, wenn das Material der Umhäusung chemisch inert ist, wofür sich beispielsweise Borosilikatglas auszeichnet. Eines der Substrate oder die Substrate können auch $Al_2O_3$, Saphir, $Si_3N_4$ oder AlN umfassen bzw. daraus bestehen.

Die äußere Flachseite des Abdecksubstrats ist bevorzugt flach ausgebildet, insbesondere planar. Das bedeutet, dass die äußere Flachseite insbesondere keine Ausbeulungen aufweist und weiter insbesondere eine maximale Deviation von einer flachen Ebene aufweist, die kleiner ist als 5 $\mu$m. Die äußere Flachseite weist insbesondere einen Mittenrauwert Ra von kleiner oder gleich 20 nm auf.

Das Abdecksubstrat ist bevorzugt in seiner Gesamtheit dünner als 200 $\mu$m. Das Abdecksubstrat ist ferner bevorzugt in seiner Gesamtheit planar aufgebaut und weist durchgehend die Dicke der umlaufenden Schmalseite auf.

Die hermetisch verschlossene Umhäusung bildet bevorzugt eine Kontaktebene oder einen Kontaktbereich des Abdecksubstrats mit dem zweiten Substrat, an welchem das Abdecksubstrat mit dem zweiten Substrat in Kontakt steht. Die Kontaktebene ist bevorzugt frei von Fremdwerkstoffen, d. h. frei von Verbindungsmaterialien, wie insbesondere Kleber oder Glasfritte. Mit anderen Worten liegt das Abdecksubstrat in Direktkontakt benachbart an dem zweiten Substrat an, wobei keine Fremdstoffe dazwischen angeordnet werden.

Das benachbart angeordnete zweite Substrat kann als Basissubstrat ausgebildet sein, wobei das Basissubstrat mit dem Abdecksubstrat mit derselben Laserbondlinie miteinander hermetisch dicht gefügt ist.

Das zweite Substrat kann auch als Zwischensubstrat ausgebildet sein, welches zwischen dem Abdecksubstrat und einem Basissubstrat angeordnet ist, wobei das Basissubstrat mit dem Zwischensubstrat in einer ersten Verbindungsebene und das Abdecksubstrat mit dem Zwischensubstrat in einer zweiten Verbindungsebene gefügt ist.

Die zumindest eine Laserbondlinie weist eine Dicke in eine Richtung senkrecht zur flächigen Erstreckungsrichtung des Abdecksubstrats auf. Die Dicke der Laserbondlinie senkrecht zur flächigen Erstreckungsrichtung des Abdecksubstrats definiert die Fügezone der Umhäusung. Die Laserbondlinie erstreckt sich dabei bis zur äußeren Flachseite, wobei insbesondere die Laserbondlinie einen Teil der äußeren Flachseite bildet. Mit anderen Worten ist die äußere Flachseite teilweise von der Laserbondlinie durchdrungen.

Im Bereich der Laserbondlinie liegt bevorzugt eine Materialmodifikation des Abdecksubstrats und/oder des benachbarten zweiten Substrats vor. Bei dieser Materialmodifikation kann es sich um eine Brechungsindexänderung und/oder eine modifizierte chemische Zusammensetzung handeln. Diese Modifikation bildet bevorzugt einen Bereich der äußeren Flachseite.

Die Breite W der Laserbondlinie kann zur Dicke D des Abdecksubstrats in einem Verhältnis stehen wie W : D größer oder gleich 1, insbesondere W : D größer oder gleich 0,5. Des Weiteren kann das Dickenverhältnis auch wie W : D größer oder gleich 0,1 oder auch W : D größer oder gleich 0,05 angegeben sein.

Der Funktionsbereich umfasst bevorzugt eine hermetisch verschlossene Beherbergungskavität, in einer bevorzugten Ausgestaltung zur Aufnahme eines Beherbergungsobjekts, wie eines elektronischen Schaltkreises, eines Sensors oder MEMS oder MOEMS.

Das Abdecksubstrat ist bevorzugt zumindest teilweise und/oder zumindest bereichsweise für einen Wellenlängenbereich transparent ausgebildet.

Im Rahmen der Erfindung liegt auch eine hermetisch verschlossene Umhäusung Die Laserbondlinie erstreckt sich dabei bis zur äußeren Flachseite, wobei insbesondere die Laserbondlinie einen Teil der äußeren Flachseite bildet.

Im Rahmen der Erfindung liegt auch ein Verfahren zum Bereitstellen einer hermetisch dichten Umhäusung, insbesondere einer Umhäusung, wie vorstehend beschrieben. Von der Umhäusung wird ein Funktionsbereich beherbergt, wobei der Funktionsbereich insbesondere als Beherbergungskavität ausgebildet ist zur Aufnahme zumindest eines Beherbergungsobjekts. Das Verfahren umfasst den Schritt Bereitstellen von zumindest einem Abdecksubstrat und einem zweiten Substrat, wobei das Abdecksubstrat ein transparentes Material umfasst. Die zumindest zwei Substrate werden direkt aneinander oder aufeinander angeordnet, so dass zwischen den zumindest zwei Substraten ein Kontaktbereich bzw. eine Kontaktfläche gebildet wird. Das Abdecksubstrat weist eine äußere Flachseite und eine umlaufende Schmalseite auf.

Die zumindest zwei Substrate werden hermetisch dicht mittels einer Laserbondlinie verschlossen, wobei die zumindest zwei Substrate entlang des zumindest einen Kontaktbereichs der Umhäusung direkt gefügt werden. Insbesondere wird hierbei die Beherbergungskavität bzw. der Funktionsbereich hermetisch dicht verschlossen, mit einer Laserbondlinie um den Funktionsbereich bzw. die Beherbergungskavität herum.

Ferner umfasst das Verfahren das Abtragen von Material des Abdecksubstrats, insbesondere zur Verringerung der Dicke des Abdecksubstrats. Das Abtragen von Material des Abdecksubstrats erfolgt insbesondere abrasiv, beispielsweise durch Abschleifen oder Sandstrahlen, woraus die Herstellung eines Dünnschichtsubstrats aus dem Abdecksubstrat resultiert, wobei die umlaufende Schmalseite eine Dicke von weniger als 200 μm erhält.

Mit anderen Worten ist es mit dem mit dieser Anmeldung vorgestellten Verfahren überhaupt möglich, eine abrasive Verdünnung bzw. einen Abtrag des Abdecksubstrats durchzuführen, ohne dass das Abdecksubstrat dabei abgeschert oder gelöst oder gar zerstört wird. Dies ermöglicht eine erhebliche Verbesserung des Herstellungsprozesses und erlaubt die Herstellung deutlich verbesserter Umhäusungen.

Dabei ist insbesondere der Abstand des Zielpunkts des Lasers, also der Ort des nichtlinearen Energieeintrags in die Umhäusung von Bedeutung. Dieser Abstand T ist groß genug gewählt, so dass die vom Laser eingebrachte Materialveränderung innerhalb der äußeren Flachseite liegt, also nicht bis an die Oberfläche des Abdecksubstrats reicht. Damit kann die deponierte Laserenergie vollständig vom Material der an dem Fügeprozess beteiligten benachbarten Substrate, d.h. beispielsweise dem Abdecksubstrat und dem zweiten Substrat, aufgenommen werden und eine vorteilhafte Fügenaht bzw. Laserbondlinie erzeugt werden, die im Ergebnis die Scherfestigkeit des Abdecksubstrats erhöht.

Durch die geschickte Wahl von T kann auch verbessert werden, dass die Zone der nichtlinearen Absorption (nlA; d.h. insbesondere der Zielpunkt des Lasers) nicht bis in das Abdecksubstrat hineinreicht. So hat sich gezeigt, dass an dem Zielpunkt durch den Laser eine Erzeugung von Fremdpartikeln vollzogen werden kann, die sich beispielsweise in einer Schwarzfärbung und/oder Änderung der Brechzahl in der nlA zeigen kann.

Überraschenderweise kann hierdurch eine Laserbondlinie erzeugt werden, die nach dem Abschleifen an der äußeren Flachseite besonders breit ausgebildet ist.

Das hermetisch dichte Verschließen der Umhäusung kann mittels eines Laser-Fügeverfahrens durchgeführt sein. Das hermetisch dichte Verschließen der Kavitäten bzw. der Umhäusung kann bei einer Temperatur durchgeführt werden, die niedriger oder höher ist als die spätere Einsatztemperatur der Umhäusung.

Die zumindest zwei Substrate werden in dem Verfahren bevorzugt als Waferstapel bereitgestellt, um aus dem Waferstapel beispielsweise eine Mehrzahl hermetisch dichter Umhäusungen gemeinsam im gleichen Arbeitsprozess herzustellen.

Das Verfahren kann ferner umfassen die Vereinzelung der Umhäusung aus einem Waferstapel, wobei der Schritt insbesondere mittels eines Laserschneid- oder Laserabtrennschritts durchgeführt wird. Bei der Vereinzelung kann insbesondere derselbe Laser eingesetzt werden, der auch für den Fügeschrift eingesetzt ist.

Mit dem zuvor beschriebenen Verfahren kann eine Umhäusung mit darin eingeschlossener hermetisch verschlossener Beherbergungskavität hergestellt werden.

Mit einer gemäß dem vorstehenden Verfahren hergestellten Umhäusung kann auch die Verwendung als medizinisches Implantat oder als Sensor folgen.

Die Erfindung umfasst auch eine Sensoreinheit und/oder medizinisches Implantat mit einer Umhäusung, wie vorstehend beschrieben, oder mit einer Substratanordnung, wie ebenfalls verstehend beschrieben.

Die Höhe HL der Laserbondlinie liegt bevorzugt in einem Bereich größer 10 μm, weiter bevorzugt größer 50 μm, größer 100 μm oder sogar größer 200 μm.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

<u>Kurzbeschreibung der Figuren</u>

Es zeigen:

| Fig. 1 | Schnitt durch eine erste Ausführungsform einer erfindungsgemäßen Umhäusung, |
|---|---|
| Fig. 2a, 2b | Beispiele für Resultate mit nachteiligen Herstellungsverfahren, |
| Fig. 3 | beispielhafte Verfahrensschritte zur Herstellung einer erfindungsgemäßen Umhäusung, |
| Fig. 4a, 4b | Detailschnitt der Fügezone, |
| Fig. 5 | Aufsicht auf eine erfindungsgemäßen Umhäusung, |
| Fig. 6 | Schnittansicht von der Seite durch die Fügezone, |
| Fig. 7a bis 7d | verschiedene Ausgestaltungen einer nichterfindungsgemäßenSubstratanordnung bzw. einer erfindungsgemäßen Umhäusung, |
| Fig. 8 | weitere Ausführungsform einer erfindungsgemäßen Umhäusung, |
| Fig. 9 | Prinzipskizze einer Fügezone, |
| Fig. 10a,b | verschiedene Ausführungen von Laserbondlinien, |
| Fig. 11 | fotografische Darstellung einer erfindungsgemäßen herzustellenden Umhäusung, |
| Fig. 12 | Draufsicht auf eine Umhäusung gemäß der Erfindung, |
| Fig. 13 | Seiten-Schnittansicht der in Fig. 12 gezeigten Umhäusung, |
| Fig. 14 | Seitenansicht der in Fig.12 gezeigten Umhäusung, |
| Fig. 15 | Draufsicht auf die in Fig. 12 gezeigten Umhäusung, |
| Fig. 16 | Seiten-Schnittansicht auf eine Laserfügezone mit einer Mehrzahl von parallel verlaufenden Laserfügelinien, vor dem Materialabtrag des Abdecksubstrats, |
| Fig. 17 | Seiten-Schnittansicht auf eine Laserfügezone mit einer Mehrzahl von parallel verlaufenden Laserfügelinien, nach dem Materialabtrag des Abdecksubstrats, |
| Fig. 18 | Graustufen-Legende zu Figuren 19, 20 und 21, |
| Fig. 19 | Seitenschnitt nach dem Polieren der Oberfläche des Abdecksubstrats, |
| Fig. 20 | Analyseergebnis vor dem Polieren der Oberfläche des Abdecksubstrats, |
| Fig. 21 | Analyseergebnis nach dem Polieren der Oberfläche des Abdecksubstrats, |
| Fig. 22 | weiteres Analyseergebnis vor dem Polieren der Oberfläche des Abdecksubstrats, |
| Fig. 23 | weiteres Analyseergebnis nach dem Polieren der Oberfläche des Abdecksubstrats. |

<u>Detaillierte Beschreibung der Erfindung</u>

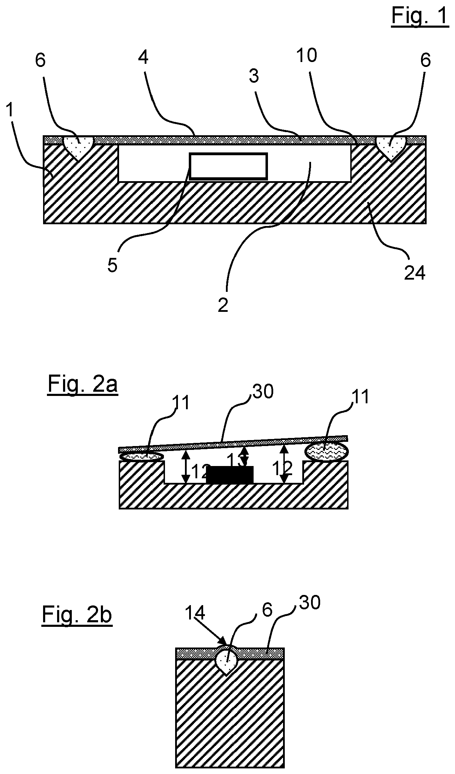

Fig. 1 zeigt eine Ausführungsform einer erfindungsgemäßen Umhäusung in einer Seiten-Schnittansicht. Die Umhäusung 1 weist ein erstes Substrat 3 als Dünnglasschicht 3 sowie ein zweites Substrat 24 auf, wobei erstes Substrat 3 und zweites Substrat 24 mittels der Fügezone 6 umlaufend hermetisch dicht gefügt sind. Eine äußere Flachseite 4 des ersten Substrat 3 zeigt in Richtung der Umgebung. Die Fügezone 6 ist im Kontaktbereich 10 zwischen erstem Substrat 3 und zweitem Substrat 24 eingebracht. Die Umhäusung 1 umschließt eine Kavität 2, in welcher ein Beherbergungsobjekt 5 angeordnet ist. Beispielsweise ist die Kavität 2 abrasiv in das zweite Substrat 24 eingebracht, also ausgehöhlt aus dem zweiten Substrat 24.

Bezugnehmend auf Fig. 2a ist eine Ausführungsform gezeigt, welche nicht die Erfindung darstellt, sondern welche die Verbindung von zwei Substraten miteinander mittels Kleber oder Fritte darstellt. Hierbei ist problematisch, dass die Verbindungsbereiche nicht äquidistant realisierbar sind, sondern Kleber oder Fritte 11 hinsichtlich der Dicke im fertigen Produkt schwanken bzw. Schwankungen unterliegen. Hierbei wird entweder die hermetische Dichtigkeit nicht realisiert oder die Abdeckung 30 liegt nicht eben oder gleichmäßig auf, so dass sich insgesamt ein schlechterer Verbund und auch eine minderwertigere Dauerbelastbarkeit der Abdeckung ergibt. Beispielhaft ist mit den Pfeilen 12 der Abstand vom Boden der gezeigten Kavität zu der Abdeckung 30 gezeigt, welche nicht gleichmäßig in der Kavität ist. Mit dem Pfeil 13 ist der Abstand von der Oberseite eines Objekts in der Kavität zu der Abdeckung 30 verdeutlicht.

Bezugnehmend auf Fig. 2b ist eine weitere schlechtere Ausführung gezeigt, die nicht die Erfindung zeigen soll, wobei die Wölbung 14 in der Abdeckung 30 sichtbar ist, welche sich beispielsweise bei einem gewöhnlichen Ultrakurzpulsverfahren einstellt. Dem ist nachteilig, dass die Oberseite der Abdeckung 30 nicht einheitlich bzw. nicht plan aufgebaut ist und diese Wölbung 14 nur äußerst schlecht nachbehandelt werden kann. Dies führt zu höheren Kosten bzw. dazu, dass das mit Fig. 2b gezeigte Produkt nicht für die erfindungsgemäßen Anwendungsgebiete eingesetzt werden kann.

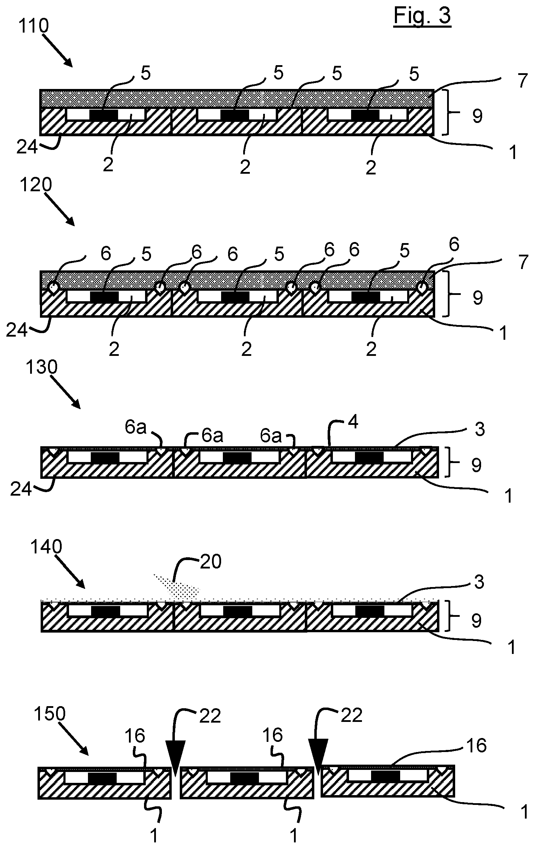

Fig. 3 zeigt beispielhaft Schritte zur Herstellung einer erfindungsgemäßen Umhäusung 1. Es werden mehrere Umhäusungen 1 aus gemeinsamen Substraten eines Substratspatels 9, beispielsweise in Form von Wafern, im gleichen Arbeitsschritt hergestellt um die Produktionskosten zu senken bzw. den Materialverschnitt zu minimieren. In einem Vorbereitungsschritt 110 wird der Stapel von Substraten 7, 24 sowie das Beherbergungsobjekt 5 zur Fertigstellung der Umhäusung 1 vorbereitet. Das erste Substrat 7 weist vor der Endfertigung eine Dicke von größer 200 $\mu$m auf, so dass sich der spätere Fügeprozess leichter und präziser durchführen lässt. Mit anderen Worten ist das Substrat vor Durchführung des Fügeprozesses noch kein Dünnschichtsubstrat. Zweites Substrat 24 und erstes Substrat 7 bilden den Waferstapel 9.

In dem Fügeschritt 120 wird vermittels eines Lasers die Fügezone bzw. Laserbondlinie 6 in die Umhäusung 1 eingebracht, wobei in diesem Beispiel der Waferstapel 9 eine Mehrzahl von Kavitäten 2, nämlich drei Kavitäten 2 aufweist. Aus dem Waferstapel 9 werden später mehrere Umhäusungen 1 vereinzelt. Um jede Kavität 1 wird eine Laserbondlinie 6 umlaufend herumgeführt und schließt die jeweilige Kavität 2 hermetisch dicht ab.

In einem Reduzierschritt 130 wird aus dem ersten Substrat 7 vor der Endfertigung das fertige Abdecksubstrat 3 als Dünnglasschicht hergestellt, beispielsweise mittels abrasivem Materialabtrag. Dies kann ein Polierschritt oder ein Sandstrahlschritt oder ähnlicher Abtrag sein, um das Dünnschichtsubstrat 3 auf eine Dicke von kleiner als 200 $\mu$m zu verringern. Bei dem Abtragschritt 130 wird auch die Laserbondlinie 6 jedenfalls teilweise abgetragen, so dass die Laserbondlinie 6 einen Teil der Oberfläche 4 der Dünnglasschicht 3 bildet, so dass eine angepasste Fügezone 6a herausgebildet wird. Das Abdecksubstrat 3 ist dabei so eingestellt, dass es in dem mit dem zweiten Substrat 24 verbundenen Zustand eine besonders hohe Scherfestigkeit aufweist.

Optional kann das Verfahren zur Herstellung der erfindungsgemäßen Umhäusung 1 einen Vergütungs- bzw. Auftragsschritt 140 aufweisen, bei dem beispielsweise ein Auftrag 20 erfolgt, bei welchen eine außenseitige Funktionsschicht 16 auf der Außenseite 4 des ersten Substrats 3 aufgebracht wird. Im Trennschritt 150 werden mittels eines Schneidwerkzeugs 22, welches auch ein Laser sein kann, wie beispielsweise der Laser, der auch zum Fügen der Umhäusung eingesetzt wird, die einzelnen Umhäusungen 1 vereinzelt. Mit anderen Worten werden aus dem Waferstapel 9 eine Mehrzahl von Umhäusungen 1 vereinzelt. Es werden daher in diesem Beispiel mehrere Umhäusungen 1 gemeinsam hergestellt, wobei sich hierdurch die Kosten des Herstellungsverfahrens weiter senken lassen.

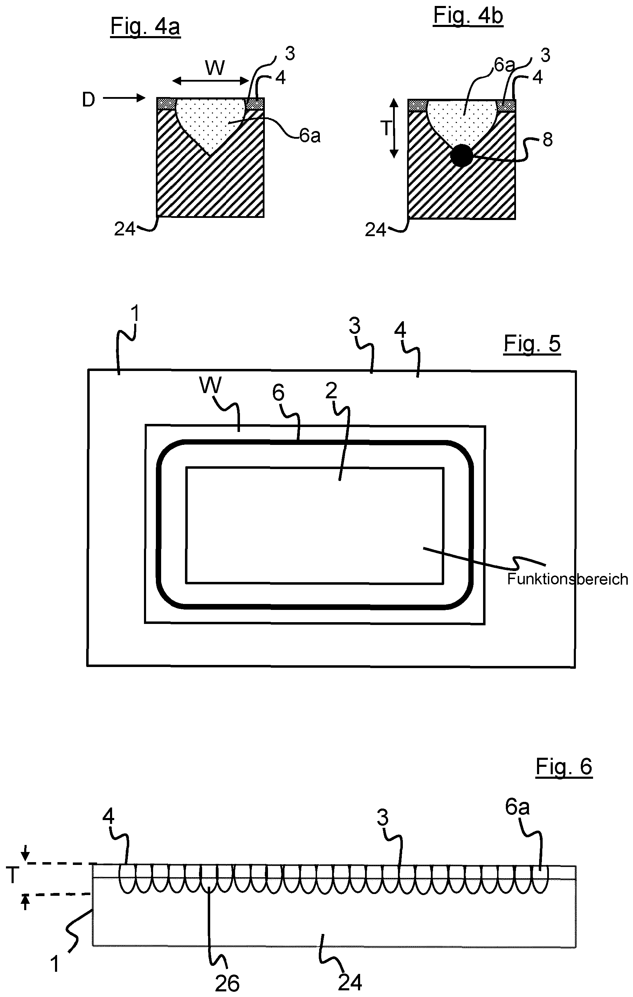

Bezugnehmend auf Fig. 4a ist ein Detail auf einen Längsschnitt durch die Laserfügezone 6 gezeigt, wobei die Laserfügezone bis an die äußere Flachseite 4 des ersten Substrats 3 heranreicht und an der äußeren Flachseite 4 die Breite W aufweist. Das erste Substrat 3 weist die Dicke D auf, beispielsweise kleiner 200 $\mu$m, in diesem Beispiel kann die Dicke des ersten Substrats 3 kleiner 100 $\mu$m sein, kleiner 70 $\mu$m, bevorzugt kleiner 50 $\mu$m oder sogar kleiner 30 $\mu$m. Die Breite bzw. der Durchmesser der Laserbondlinie 6, hier mit W bezeichnet, ist dabei breiter als die Dicke der Dünnglasschicht 3. Beispielsweise ist W 200 $\mu$m bei einer Dicke der Dünnglasschicht von 130 $\mu$m. Weiter beispielsweise ist W/D größer 1, so dass die Breite der Laserbondlinie 6 an der Außenseite 4 größer ist als die Dicke D der Dünnglasschicht 3. Das Verhältnis W/D ist weiter bevorzugt 0,5, so dass W halb so groß ist wie die Dicke D der Dünnglasschicht 3 oder größer. Das Verhältnis W/D kann auch größer oder gleich 0,1, weiter bevorzugt größer oder gleich 0,05 sein.

Typische aktuelle Laserbondlinien liegen dabei hinsichtlich ihrer Breite in einem Bereich von 10 $\mu$m bis 50 $\mu$m. Ein W/D von 0,05 würde dabei zum Beispiel mit W=10 $\mu$m und D=200 $\mu$m erreicht. Aber auch größere Werte von W/D können sinnvoll sein, beispielsweise 0,25, welches resultiert mit W=50 $\mu$m und D=200 $\mu$m.

Das erfindungsgemäße Verfahren, mittels welchem unter anderem die Dünnglasschicht 3 während des Herstellungsprozesses ausgearbeitet wird, führt zu einer besonders gut brauchbaren_Oberfläche der äußeren Flachseite 4, bei welcher insbesondere keine Wölbung oder Buckel auf der Außenseite 4 über die mittlere Dicke D der Dünnglasschicht 3 heraus steht.

Bezugnehmend auf Fig. 4b ist ergänzend zur Fig. 4a der Zielbereich 8 des Fügelasers eingezeichnet, welcher in einer Tiefe T gemessen von der Außenseite 4 eingebracht ist. T kann beispielsweise größer oder gleich 10 $\mu$m, größer oder gleich 50 $\mu$m, größer oder gleich 100 $\mu$m oder auch größer oder gleich 200 $\mu$m sein. T ist stets größer als die Dicke D der Dünnglasschicht um das erste Substrat 3 mit dem zweiten Substrats 24 hermetisch dicht zu fügen. Der Zielpunkt 8 stellt dabei den Bereich der nichtlinearen Absorption im Material und/oder der Avalanche Ionisation dar, also beispielsweise der Tiefe, die für den Keldysh-Parameter eingestellt ist. Es ist der Bereich der Laserbondlinie, an welchem ein optischer Schaden eingebracht wird, also beispielsweise ein lokal geänderter Brechungsindex oder eine Schwärzung.

Bezugnehmend auf Fig. 5 ist eine Aufsicht auf eine erfindungsgemäße Umhäusung 1 gezeigt, wobei ein Funktionsbereich 2 im Inneren der Umhäusung 1 angeordnet ist. Die Laserbondlinie 6 ist umlaufend um den Funktionsbereich 2 herum angeordnet und verschließt den Funktionsbereich 2, hier als Kavität ausgebildet, hermetisch dicht zu allen Seiten hin ab. Die Breite der Laserbondlinie B an der Außenseite 4 des ersten Substrats 3 ist beispielhaft angegeben um die Laserbondlinie 6 herum.

Bezugnehmend auf Fig. 6 ist eine Seitenschnittansicht durch eine erfindungsgemäße Umhäusung bzw. Substratanordnung entlang einer Laserbondlinie 6 gezeigt. Die Laserbondlinie 6 ist an der Oberseite zur angepassten Fügezone 6a modifiziert, welche einen Teil der Außenseite 4 des ersten Substrats bildet. Die Laserbondlinie 6 reicht dabei sowohl in das erste Substrat 3 als auch in das zweite Substrat 24 hinein.

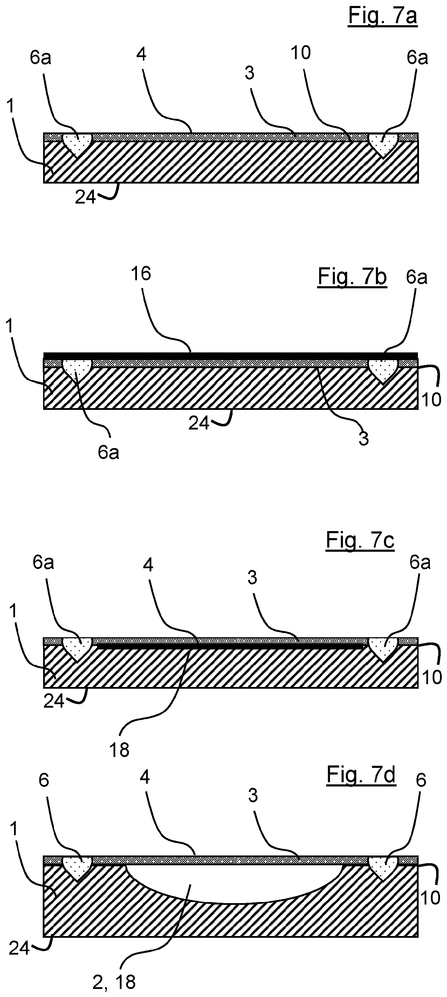

Bezugnehmend auf Fig. 7a ist eine Substratanordnung gezeigt mit einem Dünnschichtsubstrat 3 sowie einem damit hermetisch dicht verbundenen zweiten Substrat 24, welche mittels der Laserbondlinie 6 hermetisch dicht gefügt sind.

Bezugnehmend auf Fig. 7b ist die Anordnung nach Fig. 7a gezeigt, welche zusätzlich eine außenseitige Funktionsschicht 16 aufweist, beispielsweise eine optische Vergütung 16. Die außenseitige Funktionsschicht 16 weist eine homogene, d. h. gleichmäßige Dicke auf und überdeckt auch die modifizierte Funktionsschicht 6, 6a. Die Laserbondlinie 6 ist in den Kontaktbereich 10 zwischen erstem und zweitem Substrat 3, 24 eingebracht.

Bezugnehmend auf Fig. 7c ist die Anordnung nach Fig. 7a gezeigt mit einer zusätzlichen innenseitigen Funktionsschicht 18 bzw. einem inneren Funktionsbereich 18, welcher beispielsweise in das zweite Substrat 24 eingearbeitet ist oder zwischen erstem Substrat 3 und zweitem Substrat 24 angeordnet ist oder auf der Unterseite des ersten Substrats 3 angebracht sein kann. Diese Schicht 18 kann Teil der Kontaktfläche sein oder die Kontaktfläche bilden. Die Schicht 18 kann beispielsweise ein AR-Coating auf der Innenseite des Abdecksubstrats 3 sein. Sofern die Schicht 18 vollflächig ausgebildet ist wird sie im Bereich der Laserbondlinie 6, 6a beschädigt. Dies kann toleriert werden, wenn die Funktionalität der Schicht 18 dadurch nicht beeinträchtigt wird, beispielsweise wenn das Coating im Bereich der Kavität 2 erhalten bleibt.

Bezugnehmend auf Fig. 7d ist noch eine weitere Ausführungsform gezeigt, wobei die Umhäusung 1 eine Kavität 2 bzw. einen Funktionsbereich 18 beherbergt. Es kann sich bei dem Funktionsbereich 18 um eine linsenförmige Ausnehmung in dem zweiten Substrat 24 handeln, welche beispielsweise bereits durch die Form der Ausnehmung optische Eigenschaften aufweisen kann, d. h. beispielsweise als Linse fungieren. Im Gegensatz zu den Figuren 7c und 7d zeigen die Figuren 7a und 7b keine Ausführungsbeispiele der beanspruchten Erfindung.

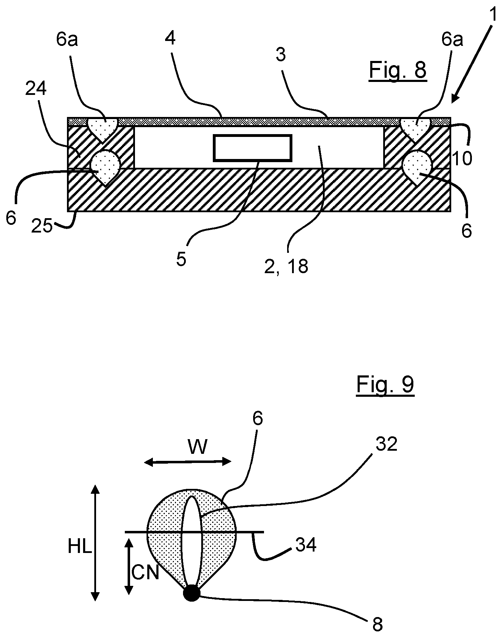

Mit Fig. 8 ist eine weitere Ausführungsform der Umhäusung 1 dargestellt, wobei mittels einer ersten Laserbondlinie 6 das zweite Substrat 24 mit einem dritten Substrat 25 hermetisch dicht gefügt ist, und wobei mittels einer zweiten Laserbondlinie 6a das zweite Substrat 24 mit dem ersten Substrat oder Abdecksubstrat 3 gefügt ist. In diesem Beispiel sind die beiden Laserbondlinien 6, 6a direkt übereinander angeordnet, diese Anordnung weist zwar Vorteile auf, die Erfindung soll aber nicht auf diese Anordnung beschränkt sein. Unter den Vorteilen dieser Anordnung ist die erwünschte maximale Ausbeute des Anteils der Kavität 2 an der Umhäusung. Die Laserbondlinie weist bevorzugt einen Mindestabstand auf zu jeder die Laserbondlinie 6, 6a umgebenden Grenzfläche bzw. Oberfläche. Da auf der einen Seite die Kavität 2 möglichst weit an die Außenseite der Umhäusung 1 heranreichen soll und auf der anderen Seite die Laserbondlinien 6, 6a einen Mindestabstand sowohl zur Kavität 2 als auch zur Außenseite der Umhäusung 1 einhalten sollen, ergibt sich die vorteilhafte Anordnung der beiden Laserbondlinien 6, 6a direkt übereinander bzw. möglichst gering versetzt zueinander. Die Laserbondlinie 6a weist eine abgeplattete Oberseite auf, die dadurch resultiert, dass das Abdecksubstrat 3 nach dem Fügevorgang abrasiv verdünnt ist um die Außenseite 4 des Abdecksubstrats 3 zu bilden. Dabei wird auch Material der Laserbondlinie 6a abgetragen.

Mit Fig. 9 ist eine Detailskizze des Aufbaus einer Laserbondlinie 6, 6a gezeigt. W bezeichnet die maximale (laterale) Breite der Schmelzregion 36, wobei die Ebene 34 die Ebene darstellt, bei welcher W gemessen ist. HL ist die Höhe der Schmelzregion 36 und CN der Abstand des Laserfokus, also dem Bereich/Punkt der nichtlinearen Absorption zu der Ebene 34, in der W gemessen wird. Im Inneren der Laserbondlinie 6, 6a ist der innere Schmelzbereich 32 angeordnet.

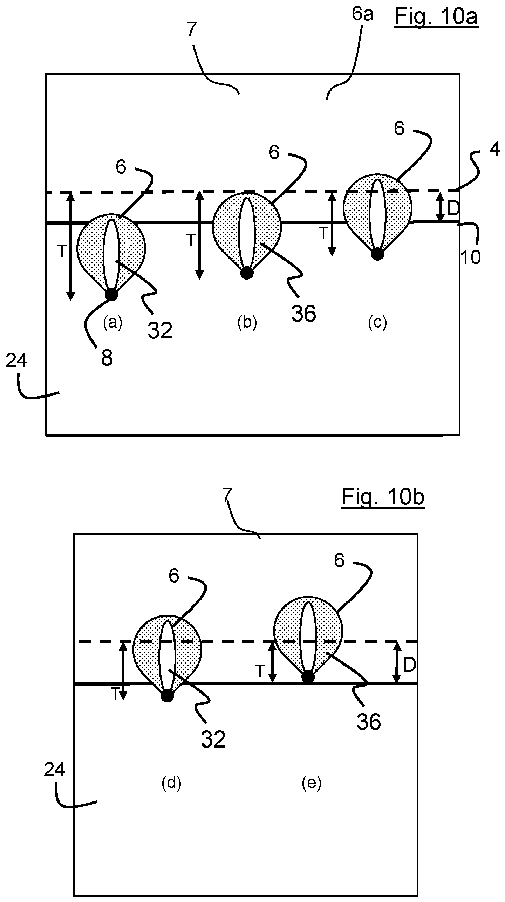

Bezug nehmend auf Fig. 10a und Fig. 10b ist eine Gegenüberstellung verschiedener Tiefen T von beispielhaften Laserfügezonen 6, 6a mit den Buchstaben a, b, c, d und e dargestellt, welche in ein Rohsubstrat 7, das ist also das Dünnschichtsubstrat 3 vor dem Materialabtrag, teilweise eingebracht wird. Die Laserfügezonen 6, 6a unterscheiden sich dabei hinsichtlich der Tiefe T mit welcher sie von oben durch das erste Substrat 7 hindurch in den Substratstapel 1 bzw. die Umhäusung 1 eingebracht werden. Die spätere Außenfläche 4 ist gestrichelt dargestellt, diese Oberfläche soll an der finalen Umhäusung die äußere Flachseite 4 bilden. Die Tiefen T werden dabei gemessen als der Abstand des Fokuspunkts 8 von der späteren äußeren Flachseite 4. D bezeichnet die Dicke des Abdecksubstrats 3 nach der abschließenden Behandlung. Bei der mit a bezeichneten Laserbondlinie 6, 6a reicht der Schmelzbereich 36 nur knapp in das Abdecksubstrat 3 hinein. Obzwar diese Anordnung auch bereits einen ausreichenden Verbund herstellt, hat sich herausgestellt, dass eine solche Anordnung ggf.empfindlich auf potenzielle Materialfehler ist, so dass also bei einem Vorliegen eines Materialfehlers bzw. einer Schwächung eines der Substrate 3, 24, 25 eine Ablösung des Abdecksubstrats oder ein Aufbrechen des hermetischen Verschlusses resultieren könnte.

Bei den mit b, c und d bezeichneten Laserbondlinien 6, 6a reicht die Konvektionszone 36 ausreichend weit in das Abdecksubstrat 7, d.h. in das spätere Dünnschichtsubstrat 3, hinein, wobei bei c und d bereits Material der Schmelzblase 36 abgetragen wird zur Herstellung des Dünnschichtsubstrats 3. Allerdings nähert sich bei der mit d bezeichneten Laserbondlinie 6, 6a die Zone der nichtlinearen Absorption 8 bereits deutlich an die Kontaktfläche 10 zwischen den Substraten 3, 24 an. In der Zone der nichtlinearen Absorption 8 wurde eine sichtbare Materialveränderung mit Trübung des Materials und/oder Änderung der Brechungszahl beobachtet. Daher wird bevorzugt, den Laserzielbereich 8 von der Kontaktfläche 10 beabstandet zu halten, was bei den Ausführungen a, b und c noch der Fall ist. Hierbei wird auch ausreichend Material der beiden Substrate 3, 24 miteinander konvektiv vermischt. Die mit e bezeichnete Ausführungsform zeigt schließlich eine Laserbondlinie 6, 6a die nicht mehr in das zweite Substrat 24 hineinreicht und keinen Verbund mehr zwischen den beiden Substraten herzustellen vermag.

Als bevorzugte Position der Laserbondlinie 6, 6a zur Herstellung eines Dünnschichtsubstratstapels bzw. einer Umhäusung 1 konnte sich daher herausstellen, wenn gilt T gleich D+CN. Dabei kann der Bereich bevorzugt herangezogen werden, bei welchem gilt T kleiner D+WH; Andererseits ist es bevorzugt, wenn T größer gewählt wird als CN, um einen Verbund zwischen dem ersten und zweiten Substrat 3, 24 herzustellen. Wenn die Ebene 34 der breitesten Ausdehnung W der Schmelzblase 36 etwa mittig in dem späteren Dünnschichtsubstrat liegt, also ungefähr bei D/2, dann gilt etwa T-CN=D/2. In allen vorgenannten Bereichen und bei den Zwischenhöhen dazu kann der Dünnschichtsubstratstapel 1 bzw. die Umhäusung 1 erfolgreich hergestellt werden.

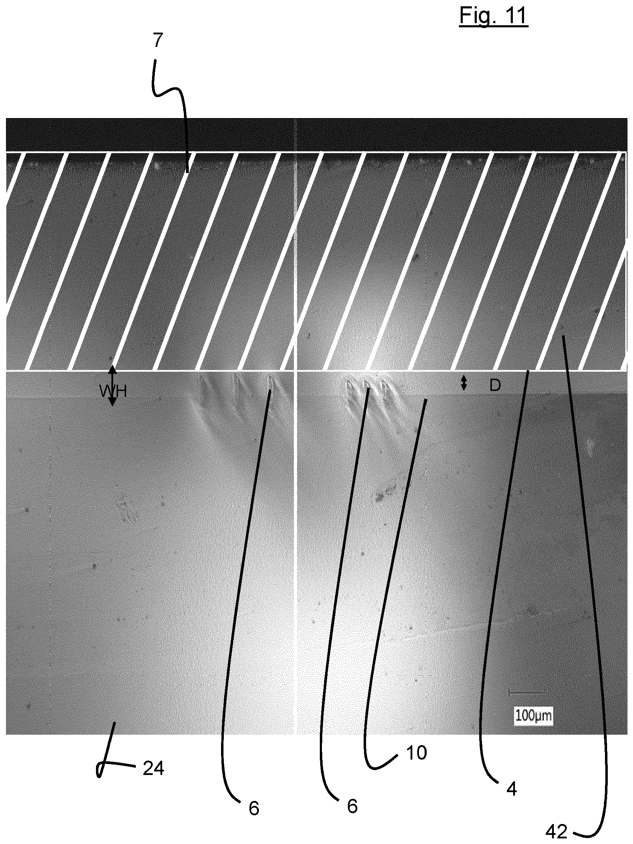

Bezug nehmend auf Fig. 11 ist eine Seitenaufsicht auf eine Umhäusung 1 bzw. einen Substratstapel 1, 9 dargestellt, bei welchem eine Mehrzahl von Laserbondlinien 6, 6a beispielhaft eingebracht sind. Ein oberer Dickenbereich 42 ist schraffiert dargestellt, welcher bis zur späteren äußeren Flachseite 4 zur Herstellung des Dünnschichtsubstrats 3 abzutragen ist. Durch die ausreichende Materialdicke des oberen Bereichs 42 ist sichergestellt, dass die Laserbondlinien 6, 6a unbeeinflusst bzw. ungestört in die Umhäusung 1 bzw. den Substratstapel 1, 9 eingebracht werden kann und ein sicherer Verbund zwischen dem Dünnschichtsubstrat 3 und dem zweiten Substrat 24 erzielbar ist.

Der Funktionsbereich 18 kann verschiedene Aufgaben realisieren, beispielsweise kann dies ein optischer Rezeptor sein oder ein technisches, elektromechanisches und/oder elektronisches Bauteil sein oder umfassen, welches in einer Kavität 2 angeordnet sein kann. Wie die Fig. 6 verdeutlicht, besteht eine Laserbondlinie 6 aus einer Mehrzahl von Laserpulstrefferbereichen 26, welche so dicht aneinandergesetzt sind, dass das Material des zweiten Substrats 24 mit dem Material des ersten Substrats 3 lückenlos miteinander verschmilzt.

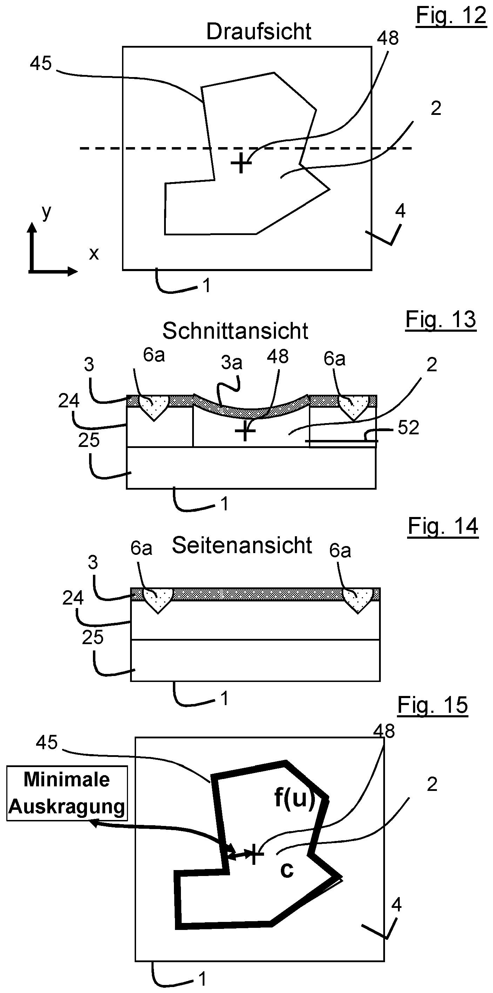

Mit Bezug auf die Figuren 12 bis 15 ist eine weitere Ausführungsform einer Umhäusung 1 gezeigt, bei welcher eine Kavität 2 bzw. ein Funktionsbereich 18 in der Umhäusung 1 hermetisch verschlossen eingehäust ist. Fig. 12 zeigt eine Draufsicht auf die Umhäusung 1, wobei obenauf das dünne Abdecksubstrat 3 die Kavität 2 überspannt. Die Kavität 2 kann unregelmäßig geformt sein wie in diesem Beispiel, und hinsichtlich des Bauraums oder anderweitiger Anforderungen der eingesetzten zu beherbergenden Bauteile 5 optimiert. Die hier gezeigte Ausführungsform der Umhäusung 1 kann als Drucksensor 1 ausgestaltet sein.

Fig. 13 zeigt den Drucksensor 1 in seitlicher Darstellung. Das Abdecksubstrat 3 ist auf eine Dicke von etwa 100 bis 150 $\mu$m, hier konkret 130 $\mu$m ausgedünnt, bzw. poliert. Das Abdecksubstrat 3 überspannt mit dem Teilstück 3a die Kavität 2. Das Abdecksubstrat 3 ist dünn genug, dass es im freitragenden Teilstück 3a Druckschwankungen oder Druckwerte mit einer Verformung ausgleichen kann. Die Verformung des freitragenden Teilstücks 3a kann wiederum beispielsweise durch optische Messung erfasst werden und daraus beispielsweise ein Druckabsolutwert, -relativwert oder Druckänderung abgeleitet werden.

Der Aufbau des Abdecksubstrats 3, bei welchem zunächst ein dickeres Substrat mit dem zweiten Substrat 24 gefügt wird und das Abdecksubstrat 3 nach dem Laserfügen auf die gewünschte Dicke ausgedünnt wird, beispielsweise durch Polieren, kann ein noch festeres bzw. geeigneteres Abdecksubstrat 3 bereitstellen, welches höhere Druckdifferenzen zwischen Innenraum der Kavität 2 und Umgebung auszuhalten vermag, ohne zerstört zu werden. Insbesondere deswegen, weil der Schritt des Materialabtrags von Material des Abdecksubstrats 3 Materialspannungen im Abdecksubstrat 3 verringert und dadurch die Festigkeit und/oder Verformbarkeit des Abdecksubstrats 3 verbessert. Der hermetische Verschluss der Kavität 2 mittels der umlaufenden Laserbondlinie 6a, die die Kavität 2 vollständig umschließt, ist ein Schlüsselelement dafür, dass Druckunterschiede zwischen dem Innenraum der Kavität 2 und der Umgebung zuverlässig aufrecht erhalten bleiben und Druckmessungen zuverlässig durchführbar sind.

Durch die Biegsamkeit K des Abdecksubstrats 3 im Bereich der Kavität 2, die von dem Abdecksubstrat 3 mit dem Teil 3a überspannt ist, können auch optische Eigenschaften realisiert werden, wenn der Teil 3a als Linse bzw. generell mit optischen Eigenschaften aufgefasst wird. Einerseits kann dadurch auf optischem Wege der vorherrschende Druck bzw. Druckunterschied gemessen werden, da sich die optischen Eigenschaften des Teils 3a mit zunehmender Biegung verändern; Andererseits kann durch die Einstellung eines Drucks bzw. Druckdifferenz auch eine gewünschte optische Eigenschaft eingestellt werden. Bspw. kann eine Optik scharf gestellt werden, also der Brennpunkt des Teils 3a eingestellt werden. So könnte im Inneren der Kavität 2 auch ein optischer Sensor angeordnet sein, und mittels Druckänderungen der optische Fokus der in die Kavität 2 einfallenden Strahlung variiert werden. Hierfür kann auch ein einstellbarer Durchlass 52 vorgesehen sein, mittels welchem ein Druckausgleich und/oder eine Druckänderung im Innenraum der Umhäusung 1 bzw. in der Kavität 2 erwirkt werden kann. Beispielsweise kann an oder in dem Durchlass 52 hierfür eine Pumpe oder Ventil angeordnet sein. Beispielsweise kann im Innenraum bzw. der Kavität 2 auch eine Flüssigkeit angeordnet sein, und die optischen Eigenschaften des Teils 3a durch Zufluss oder Abfluss von Flüssigkeit durch den Durchlass 52 eingestellt werden.

Das zweite Substrat 24 kann entweder ein durchgängiges Substrat 24 sein, beispielsweise aus einem Wafer, welches "Löcher" bzw. Ausnehmungen an den Stellen der späteren Kavitäten 2 aufweist, oder es können "Spacer" eingesetzt sein, also Abstandsstücke zwischen erstem Substrat 3 und drittem Substrat 25. Fig. 14 zeigt schließlich die Umhäusung in Seitenansicht, wobei die Schichtanordnung der drei Schichten 3, 24, 25 ersichtlich ist.

Bezugnehmend auf Fig. 15 wird ein weiterer Zusammenhang erläutert. Mit der kontinuierlichen oder diskreten (mit Anzahl U von Punkten) 2D-Funktion von Punkten f(u) wird die Umrandung der Kavität 2 bzw. des Funktionsbereichs 18 beschrieben. Mit der Dicke D des Abdecksubstrats 3 kann ein K-Faktor definiert werden wie folgt:

$$K = \frac{\min\left(\sqrt{(f_x(u) - c_x)^2 + (f_y(u) - c_y)^2}\right)}{D}$$

c entspricht hierbei den Koordinaten des Mittelpunkts 48, oder auch Baryzentrum, der Kavität 2 und kann wie folgt erhalten werden:

$$\vec{c} = \int \vec{f}\, du$$

oder im disktreten Fall:

$$\vec{c} = \frac{1}{U} \sum_u \vec{f}$$

Der K-Faktor stellt ein Maß bereit zur Abschätzung oder Berechnung der Biegsamkeit des Abdecksubstrats 3. Die Biegsamkeit K liegt dann bevorzugt im Bereich 5 bis 15, weiter bevorzugt im Bereich 7 bis 12.

Bei einer Dicke des Abdecksubstrats von 150 μm kann der K-Wert dann in einem Beispiel erhalten werden zu K = 1,25 mm / 0,15 mm = 8,33.

Mit anderen Worten weist die Umhäusung 1 hinsichtlich des Abdecksubstrats eine Biegsamkeit K auf, wobei der rechnerische Wert für die Biegsamkeit K ≥ 3, bevorzugt K ≥ 5, weniger bevorzugt K ≥ 7 ist, und/oder wobei K ≤ 18, bevorzugt K ≤ 15, und weniger bevorzugt K ≤ 12 ist. Mögliche Intervalle für die Biegsamkeit eines Abdecksubstrats 3, die im Rahmen der Erfindungslegung als vorteilhaft bestimmt wurden, können dann sein 3 ≤ K ≤ 18, bevorzugt 5 ≤ K ≤ 15, oder weiter bevorzugt 7 ≤ K ≤ 12, wobei auch die übrigen Zahlenkombinationen für das Werteintervall von K vorteilhaft sein können.

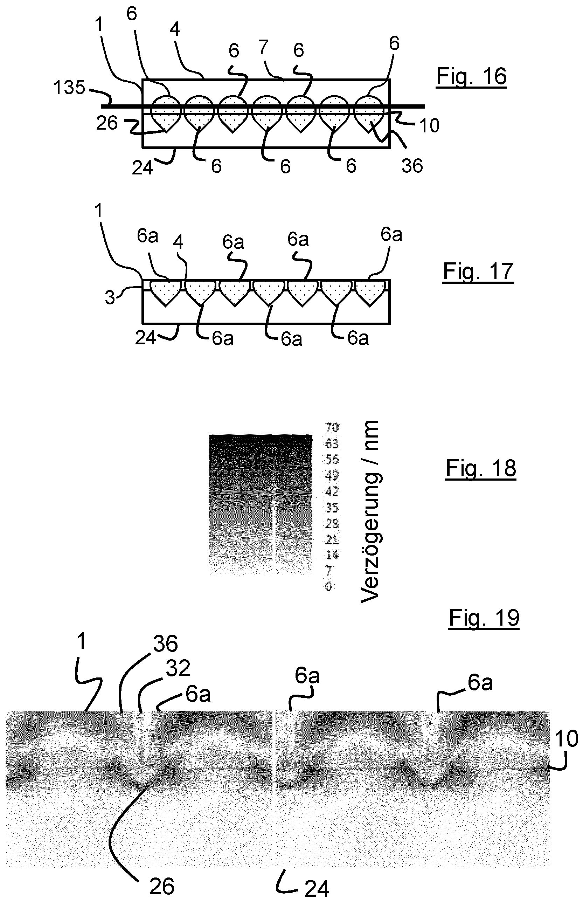

Figuren 16 bis 23 nehmen Bezug auf eine weitere Ausführungsform einer Umhäusung 1, wobei der die überraschende Verbesserung hinsichtlich der Eigenspannungen im Material des Abdecksubstrats 3 anschaulich dargestellt wird. So zeigt Fig. 16 einen Querschnitt durch eine Umhäusung 1 vor dem Materialabtrag vom Abdecksubstrat 7. Zu Testzwecken, um die Materialspannung besser zu erfassen, ist eine Mehrzahl von Laserfügelinien 6 parallel und mehr oder weniger äquidistant zueinander in den Materialverbund aus Abdecksubstrat 7 und Basissubstrat 24 eingebracht. Das Abdecksubstrat 7 entspricht vor der Endbearbeitung zunächst mit 1800 μm Dicke der Dicke des Basissubstrats 24 mit ebenfalls 1800 μm Dicke. Das Abdecksubstrat 7 wird, zum Beispiel durch abrasives Polieren, oder auch durch Sandstrahlen, bis zur angezeigten Reduzierlinie 135 abgetragen und wird dann zum dünnen Abdecksubstrat 3, beispielsweise einer Dünnglasschicht. Die Reduzierlinie 135 entspricht somit einem Abtragsziel. In diesem Fall sind als Abtragsziel 135 eine Restdicke von 100 μm für das Abdecksubstrat 3 eingestellt, so dass die Umhäusung eine Gesamtdicke von noch 1900 μm erhält.

Die Laserfügelinien 6 reichen etwa ähnlich weit in die beiden Substrate 7, 24, wobei die Form der Laserfügelinien 6 ausführlich mit Figuren 4a, 4b, Fig. 9, 10a und 10b erläutert und gezeigt ist. Die in den vorgenannten Figuren gezeigten Merkmale der Laserfügelinien sind inhärent auch in den Figuren 16 bis 23 vorhanden, und nur aufgrund der höheren Übersichtlichkeit sind nicht alle Bezugszeichen in diesen Figuren wiederholt. So ist der Zielpunkt des Laserfokus im Basissubstrat 24, und der Punkt der nichtlinearen Absorption 26 dort verortet. Die Konvektionszone 36 erstreckt sich vom Basissubstrat 24 bis in das Abdecksubstrat 7, wobei in der Konvektionszone 36 Material des Basissubstrats 24 mit Material des Abdecksubstrats 7 vermischt ist. Dadurch wird ein nicht-lösbarer Verbund der beiden miteinander gefügten Substrate 3, 24 erhalten. Zugleich ist, wie bereits ausgeführt, ein sicheres Erzeugen der Laserfügelinien 6 ermöglicht, wenn das Abdecksubstrat 7 vor der Endbearbeitung eine größere Dicke aufweist, da dann kein Materialabbrand erfolgt, und ein vollständiger und schlüssiger Materialaustausch in den Konvektionszonen 36 erfolgt. Hernach erfolgt der Materialabtrag 130 des Abdecksubstrats 7.

Mit Fig. 17 ist die Umhäusung 1 mit abgetragenem Abdecksubstrat 3 gezeigt, wobei modifizierte Laserfügelinien 6a erzeugt sind. Das Abdecksubstrat 3 ist bis zum Abtragsziel 135 abgetragen, weist also eine Dicke von 100 μm auf. Das Basissubstrat weist nach wie vor eine Dicke von 1800 μm auf (die Zeichnung ist entsprechend nicht zu den Figuren 19 bis 23 maßstäblich, da im exakten Maßstab das Abdecksubstrat 3 kaum mehr sichtbar wäre). Wie mit Fig. 17 ersichtlich, wird in diesem Beispiel ein wesentlicher Anteil der Außenseite 4 des Abdecksubstrats 3 von den modifizierten Laserfügelinien 6a gebildet, welche bis an bzw. in die Außenseite 4 hineinreichen. Die mit Fig. 17 gezeigte Ausführungsform entspricht im Aufbau auch der für mit Figuren 19 bis 23 gezeigten Messergebnisse.

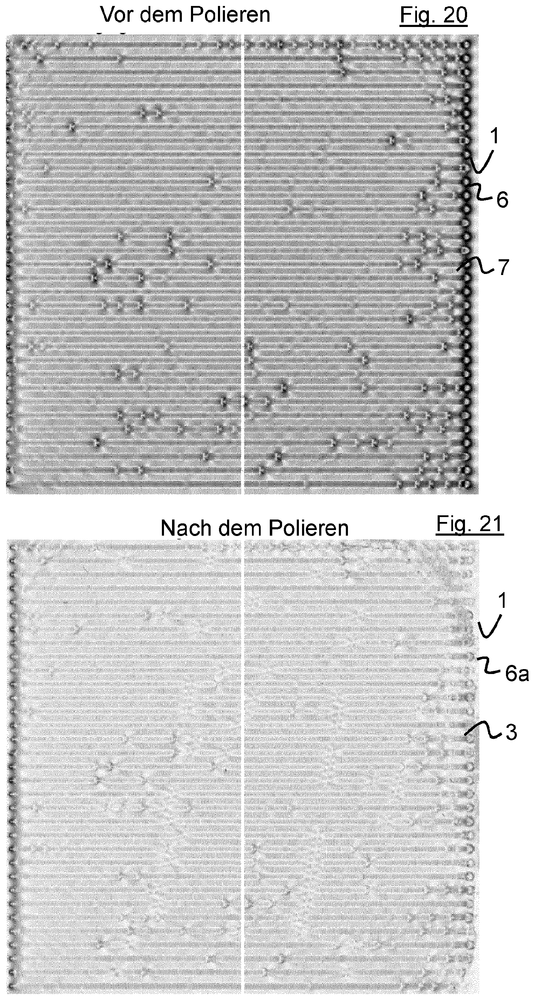

Bezug nehmend auf Fig. 18 ist eine Graustufenskala gezeigt, mittels welcher der in Figuren 19, 20 und 21 gezeigten Graustufen ein Verzögerungswert zugeordnet werden kann. Für die Figuren 20 und 21 reicht die Skala von einer Verzögerung von 0 nm für weiß bis zu 70 nm für schwarz und der Wertebereich ist linear zwischen den Werten von 0 bis 70 nm aufgelöst. Im Falle der Figur 19 entspricht der Wert weiß ebenfalls 0 nm, schwarz hingegen entspricht 180 nm Verzögerung. Der Bereich von 0 bis 180 nm Verzögerung ist für die Darstellung der Fig. 19 ebenfalls linear von weiß bis schwarz über die gezeigten Graustufen aufgelöst.

Bezug nehmend auf Figuren 19, 20 und 21 sind Darstellungen von Verzögerungsmessungen einer gefügten und, im Falle der Fig. 19 und 21 polierten, Umhäusung 1 dargestellt. Die Umhäusung 1, die in Fig. 20 gezeigt ist, entspricht in ihrem Aufbau der im Querschnitt gezeigten Darstellung der Fig. 16, wobei die in Fig. 21 gezeigte Abbildung im Aufbau dem in Fig. 17 gezeigten Querschnitt entspricht. Die Mehrzahl an nebeneinanderliegenden Laserfügelinien 6, 6a ist in den Figuren 19, 20, 21 deutlich sichtbar. Die Verzögerung (Eng.: retardance) bezeichnet dabei die Verzögerung, die zum Beispiel in einem doppelbrechenden Kristall oder anderem doppelbrechenden Medium zwischen den beiden senkrecht zueinander polarisierten Lichtstrahlen entsteht/vorhanden ist. Wie zuvor erläutert, kann diese im vorliegenden Fall Aufschluss über die Biegefähigkeit K des Abdecksubstrats 3 geben.

Fig. 19 zeigt einen Querschnitt durch die Umhäusung 1, wobei die gemessene Verzögerung im Material dargestellt ist. Deutlich können bereits anhand der Verzögerung die Laserbondlinien 6a erkannt werden mit den Laserzielpunkten, also den nichtlinearen Absorptionsbereich 26, der inneren Schmelzzone 32 und der Konvektionszone 36. Auch der Kontaktbereich 10 zwischen Abdecksubstrat 3 und Basissubstrat 24 ist erkennbar. Auch Bereiche, die zuvor hohe Verzögerungswerte aufwiesen, sind im geschliffenen Substrat 3 der Umhäusung 1 über mehrere Laserbondlinien 6a hinweg homogenisiert.

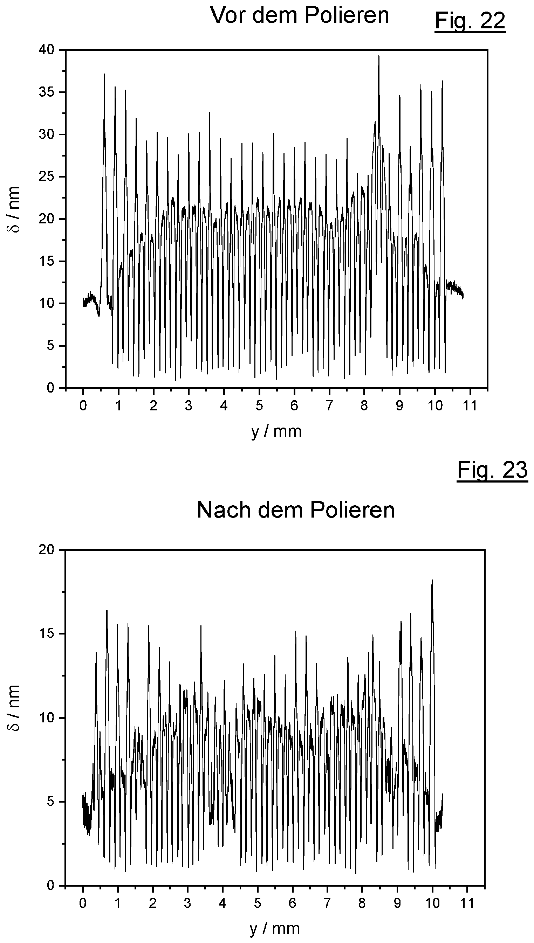

Im direkten Vergleich zwischen den Abbildungen der Figuren 20 und 21 wird ersichtlich, dass die Fig. 20 deutlich dunkler ist, also eine größere Verzögerung aufweist. Daraus kann geschlossen werden, dass im Material des Abdecksubstrats 3 der in Fig. 20 abgebildeten Umhäusung 1 eine größere Restspannung oder Eigenspannung vorhanden ist als nach dem Materialabtrag, welcher Zustand mit Fig. 21 abgebildet ist. Der gleiche Zusammenhang wird mit den beiden Graphen der Figuren 22 und 23 weiter deutlich, bei welchen die erhaltenen Verzögerungswerte über einen Querschnitt der Umhäusung 1 dargestellt sind. Deutlich wird, dass die Eigenspannung, die Einfluss auf die Grundlage der gemessenen Verzögerungswerte hat, nach dem Materialabtrag auf das Abtragsziel 135 etwa um den Faktor 2 reduziert werden kann. D.h. in dem mit Fig. 22 gezeigten Fall vor Materialabtrag ist die gemessene Verzögerung etwa doppelt so groß wie in dem mit Fig. 23 gezeigten Fall nach Materialabtrag.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne den Schutzbereich der Ansprüche zu verlassen.

In allen Figuren bezeichnen gleiche Bezugszeichen gleiche Merkmale, so dass Beschreibungen von Merkmalen, die ggf. nur in einer oder jedenfalls nicht hinsichtlich aller Figuren erwähnt sind, auch auf diese Figuren übertragen werden können, hinsichtlich welchen das Merkmal in der Beschreibung nicht explizit beschrieben ist.

**Patentansprüche**

**1.** Hermetisch verschlossene Umhäusung (1) umfassend

zumindest ein flächig ausgedehntes Abdecksubstrat (3) aufweisend eine äußere Flachseite (4) und eine umlaufende Schmalseite,

und ein zu dem Abdecksubstrat benachbart angeordnetes und mit dem flächig ausgedehnten Abdecksubstrat in direktem Kontakt stehendes zweites Substrat (24),

zumindest einen von der Umhäusung umschlossenen Funktionsbereich (2, 18), welcher insbesondere zwischen dem Abdecksubstrat und dem zweiten Substrat angeordnet ist,

wobei das Abdecksubstrat als transparentes Dünnschichtsubstrat ausgebildet ist, wobei das Abdecksubstrat eine Dicke von weniger als 200 μm aufweist, **dadurch gekennzeichnet, dass** die hermetisch verschlossene Umhäusung (1) eine Laserbondlinie (6, 6a) umfasst, mittels welcher das Abdecksubstrat (3) mit dem zu dem Abdecksubstrat benachbart angeordneten zweiten Substrat (24) direkt hermetisch dicht gefügt ist.

2. Hermetisch verschlossene Umhäusung (1) nach dem vorstehenden Anspruch, wobei die Dicke des Abdecksubstrats (3) an der umlaufenden Schmalseite des Abdecksubstrats gemessen ist, und/oder wobei das Abdecksubstrat (3) eine Dicke von weniger als 170 μm aufweist, bevorzugt weniger als 150 μm, weiter bevorzugt weniger als 125 μm und/oder eine Dicke größer als 10 μm aufweist, weiter bevorzugt größer als 20 μm.

3. Hermetisch verschlossene Umhäusung (1) nach mindestens einem der vorstehenden Ansprüche, aufweisend wenigstens eines der folgenden Merkmale

- die Laserbondlinie weist eine Breite W in einer Richtung parallel zur flächigen Erstreckungsrichtung des Abdecksubstrats auf, insbesondere eine Breite an der äußeren Flachseite des Abdecksubstrats, und

das Abdecksubstrat weist in dem mit dem zweiten Substrat verbundenen Zustand eine erhöhte Scherfestigkeit auf;
die Laserbondlinie (6, 6a) weist eine ursprüngliche Höhe HL auf, und das Abdecksubstrat (3) weist weniger als die Hälfte der Dicke im Vergleich zu HL auf, und/oder
es gilt

$$T < D + WH \text{ und/oder } T > CN;$$

- die äußere Flachseite (4) weist zumindest eines der folgenden Merkmale auf:

eine Beschichtungslage (16) und/oder
einen Nanoaufdruck oder eine Nanoprägung (16), und/oder
einen Funktionsbereich (16);

- die äußere Flachseite (4) des Abdecksubstrats (3) ist **dadurch gekennzeichnet, dass** sie flach ausgebildet ist, insbesondere planar, insbesondere keine Ausbeulungen aufweist, weiter insbesondere eine maximale Deviation von der flachen Ebene aufweist, die kleiner ist als 5 μm, weiter insbesondere einen Mittenrauwert Ra von kleiner oder gleich 20 nm aufweist und/oder
das Abdecksubstrat (3) ist in seiner Gesamtheit dünner als 200 μm, insbesondere planar aufgebaut und weist durchgehend die Dicke der umlaufenden Schmalseite weist auf;
- das Abdecksubstrat (3) bildet mit dem zweiten Substrat (24) eine Kontaktebene oder einen Kontaktbereich (10), an welcher/m das Abdecksubstrat mit dem zweiten Substrat in Kontakt steht, wobei die Kontaktebene frei von Fremdwerkstoffen ist, insbesondere frei ist von Verbindungsmaterialien wie Kleber oder Glasfritte;
- das benachbart angeordnete zweite Substrat (24) ist ein Basissubstrat, und

das Basissubstrat ist mit dem Abdecksubstrat mit derselben Laserbondlinie (6, 6a) miteinander hermetisch dicht gefügt, oder
das benachbart angeordnete zweite Substrat ist ein Zwischensubstrat, welches zwischen dem Abdecksubstrat und einem Basissubstrat angeordnet ist, das Basissubstrat ist mit dem Zwischensubstrat in einer ersten Verbindungsebene gefügt und das Abdecksubstrat ist mit dem Zwischensubstrat in einer zweiten Verbindungsebene gefügt;

- die zumindest eine Laserbondlinie (6, 6a) weist eine Dicke WH in einer Richtung senkrecht zur flächigen Erstreckungsrichtung des Abdecksubstrats (3) auf, und
die Laserbondlinie erstreckt sich bis zur äußeren Flachseite (4), wobei insbesondere die Laserbondlinie einen Teil der äußeren Flachseite bildet;
- im Bereich der Laserbondlinie (6, 6a) liegt eine Materialmodifikation des Abdecksubstrats (3) und/oder des benachbarten zweiten Substrats (24) vor, insbesondere eine Brechungsindexänderung und/oder eine modifizierte chemische Zusammensetzung, und diese Materialmodifikation bildet einen Bereich der äußeren Flachseite (4).

4. Hermetisch verschlossene Umhäusung (1) nach Anspruch 3,

wobei die Breite W der Laserbondlinie (6, 6a) größer ist als die Dicke D des Abdecksubstrats (3), und/oder wobei die Breite W der Laserbondlinie (6, 6a) im Verhältnis steht zur Dicke D des Abdecksubstrats (3) wie W/D größer oder gleich 1, insbesondere W/D größer oder gleich 0,05.

5. Hermetisch verschlossene Umhäusung (1) nach mindestens einem der vorstehenden Ansprüche, wobei der Funktionsbereich (2, 18) eine hermetisch verschlossene Beherbergungskavität zur Aufnahme eines Beherbergungsobjekts (5), wie eines elektronischen Schaltkreises, eines Sensors oder MEMS, umfasst.

6. Hermetisch verschlossene Umhäusung (1) nach mindestens einem der vorstehenden Ansprüche, wobei das Abdecksubstrat (3) zumindest teilweise und/oder zumindest bereichsweise für einen Wellenlängenbereich transparent ist.

7. Hermetisch verschlossene Umhäusung (1) nach mindestens einem der vorstehenden Ansprüche, wobei das Abdecksubstrat (3) aus Glas, Glaskeramik, Silizium, Saphir oder einer Kombination der vorgenannten Materialien besteht, oder wobei das Abdecksubstrat aus keramischem Material besteht, insbesondere oxidkeramisches Material, umfasst.

8. Hermetisch verschlossene Umhäusung(1) nach einem der Ansprüche 1 bis 7,
wobei sich die Laserbondlinie (6, 6a) bis zur äußeren Flachseite (4) erstreckt, wobei insbesondere die Laserbondlinie (6, 6a) einen Teil der äußeren Flachseite (4) bildet.

9. Verfahren zum Bereitstellen einer hermetisch dichten Umhäusung (1), wobei von der Umhäusung ein Funktionsbereich (2, 18) beherbergt wird, wobei der Funktionsbereich insbesondere als Beherbergungs-Kavität (2) ausgebildet ist zur Aufnahme zumindest eines Beherbergungsobjekts (5), mit den Schritten:

- Bereitstellen von zumindest einem Abdecksubstrat (3) und einem zweiten Substrat (24),

wobei das Abdecksubstrat ein transparentes Material umfasst,
wobei die zumindest zwei Substrate direkt aneinander oder aufeinander angeordnet sind, so dass zwischen den zumindest zwei Substraten ein Kontaktbereich (10) gebildet wird, und
wobei das Abdecksubstrat eine äußere Flachseite (4) und eine umlaufende Schmalseite aufweist,

- hermetisch dichtes Verschließen der Umhäusung durch direktes Fügen der zumindest zwei Substrate miteinander entlang des zumindest einen Kontaktbereichs der Umhäusung mittels einer Laserbondlinie (6, 6a),
- Abtragen von Material des Abdecksubstrats, insbesondere abrasives Abtragen beispielsweise durch Abschleifen, und dadurch Herstellen eines Dünnschichtsubstrats aus dem Abdecksubstrat, wobei die umlaufende Schmalseite eine Dicke von weniger als 200 $\mu$m erhält.

10. Verfahren nach Anspruch 9,

wobei das hermetisch dichte Verschließen der Umhäusung (1) und/oder der Kavität (2) mittels eines Laser-Fügeverfahrens durchgeführt wird, und/oder
wobei das hermetisch dichte Verschließen der Umhäusung (1) und/oder Kavität (2) bei einer Temperatur durchgeführt wird, die niedriger oder höher ist als die spätere Einsatztemperatur der Umhäusung.

11. Verfahren nach mindestens einem der vorstehenden Verfahrensansprüche, wobei die zumindest zwei Substrate (3, 24, 25) als Wafer-Stapel (9) bereitgestellt werden, um aus dem Wafer-Stapel eine Mehrzahl hermetisch dichter Umhäusungen (1) gemeinsam im gleichen Arbeitsprozess herzustellen.

12. Verfahren nach mindestens einem der vorstehenden Verfahrensansprüche, ferner umfassend den Schritt Vereinzelung der Umhäusung (1) aus einem Waferstapel (9), wobei der Schritt insbesondere mittels eines Laser-Schneid- oder Laser-Abtrenn-Schritts durchgeführt wird, wobei weiter insbesondere derselbe Laser eingesetzt wird, der auch für den Füge-Schritt eingesetzt wird.

13. Verwendung einer nach dem vorstehenden Verfahren hergestellten Umhäusung (1) mit darin eingeschlossener hermetisch verschlossener Beherbergungs-Kavität (2) als medizinisches Implantat oder als Sensor.

14. Sensoreinheit und/oder medizinisches Implantat umfassend eine Umhäusung (1) nach mindestens einem der Ansprüche 1 bis 8.

**Claims**

1. Hermetically sealed enclosure (1) comprising at least one flat cover substrate (3) having an outer flat face (4) and a circumferential edge face,

   and a second substrate (24) arranged adjacent to the cover substrate and in direct contact with the flat cover substrate,
   at least one functional area (2, 18) enclosed by the enclosure which is arranged in particular between the cover substrate and the second substrate,
   wherein the cover substrate is configured as a transparent thin-film substrate, wherein the cover substrate has a thickness of less than 200 $\mu$m, **characterized in that** the hermetically sealed enclosure (1) comprises a laser bonding line (6, 6a) by means of which the cover substrate (3) is directly hermetically sealed to the second substrate (24) arranged adjacent to the cover substrate.

2. Hermetically sealed enclosure (1) according to the preceding claim, wherein the thickness of the cover substrate (3) is measured at the circumferential edge face of the cover substrate, and/or wherein the cover substrate (3) has a thickness of less than 170 $\mu$m, preferably less than 150 $\mu$m, more preferably less than 125 $\mu$m, and/or a thickness greater than 10 $\mu$m,
   further preferably greater than 20 $\mu$m.

3. Hermetically sealed enclosure (1) according to at least one of the preceding claims, having at least one of the following features

   - The laser bonding line has a width W in a direction parallel to the planar surface direction of extension of the cover substrate, in particular a width at the circumferential edge face of the cover substrate, and the cover substrate exhibits increased shear strength when bonded to the second substrate;
   the laser bonding line (6, 6a) has an original height HL, and the cover substrate (3) has less than half the thickness compared to HL, and/or T < D+WH and/or T > CN;
   - the outer flat face (4) has at least one of the following features: a coating layer (16) and/or
   a nanoimprint or nanoembossing (16), and/or a functional area (16);
   - the outer flat face (4) of the cover substrate (3) is **characterized in that** it is flat, in particular planar, in particular has no bulges, further in particular has a maximum deviation from the flat plane that is less than 5 pm, further in particular has an arithmetic mean deviation of the roughness profile Ra of less than or equal to 20 nm, and/or the cover substrate (3) has an overall thickness of less than 200 $\mu$m, is in particular planar, and consistently exhibits the thickness of the circumferential edge face throughout;
   - the cover substrate (3) forms a contact plane or contact area (10) with the second substrate (24) at which the cover substrate is in contact with the second substrate, wherein the contact plane is free of foreign materials, in particular free of bonding materials such as adhesive or glass frit;
   - the adjacent second substrate (24) is a base substrate, and the base substrate is hermetically sealed to the cover substrate with the same laser bonding line (6, 6a), or the second substrate arranged adjacent thereto is an intermediate substrate which is arranged between the cover substrate and a base substrate, the base substrate being connected to the intermediate substrate in a first bonding plane, and the cover substrate is bonded to the intermediate substrate in a second bonding plane;
   - the at least one laser bonding line (6, 6a) has a thickness WH in a direction perpendicular to the planar direction of extension of the cover substrate (3), and the laser bonding line extends to the outer flat face (4), wherein in particular the laser bonding line forms part of the outer flat face;
   - the area of the laser bonding line (6, 6a) exhibits a material modification of the cover substrate (3) and/or the adjacent second substrate (24), in particular a change in refractive index and/or a modified chemical composition, and this material modification forms an area of the outer flat face (4).

4. Hermetically sealed enclosure (1) according to claim 3,

   wherein the width W of the laser bonding line (6, 6a) is greater than the thickness D of the cover substrate (3), and/or
   wherein the width W of the laser bonding line (6, 6a) has a relation to the thickness D of the cover substrate (3) such as W/D greater than or equal to 1, in particular W/D greater than or equal to 0.05.

5. Hermetically sealed enclosure (1) according to at least one of the preceding claims, wherein the functional area (2, 18) has a hermetically sealed housing cavity for accommodating a housing object (5), such as an electronic circuit, a sensor, or MEMS.

6. Hermetically sealed enclosure (1) according to at least one of the preceding claims, wherein the cover substrate (3) is at least partially and/or at least in some areas transparent in a wavelength range.

7. Hermetically sealed enclosure (1) according to at least one of the preceding claims, wherein the cover substrate (3) consists of glass, glass-ceramic, silicon, sapphire, or a combination of the aforementioned materials, or wherein the cover substrate consists of ceramic material, in particular oxide ceramic material.

8. Hermetically sealed enclosure (1) according to one of claims 1 to 7, wherein the laser bonding line (6, 6a) extends to the outer flat face (4), wherein
   in particular the laser bonding line (6, 6a) forms part of the outer flat face (4).

9. Method for providing a hermetically sealed enclosure (1), wherein a functional area (2, 18) is housed by the enclosure, wherein the functional area is designed in particular as a housing cavity (2) for accommodating at least one housing object (5), comprising the steps:

   - providing at least one cover substrate (3) and a second substrate (24), wherein the cover substrate comprises a transparent material,

     wherein the at least two substrates are arranged directly adjacent to or on top of each other,
     so that a contact area (10) is formed between the at least two substrates, and wherein the cover substrate has an outer flat face (4) and a circumferential edge face,

   - hermetically sealing the enclosure by directly joining the at least two substrates together along at least one contact area of the housing by means of a laser bonding line (6, 6a),
   - removing material from the cover substrate, in particular removing abrasively, for example by grinding, thereby producing a thin-film substrate from the cover substrate, wherein the circumferential edge face has a thickness of less than 200 $\mu$m.

10. Method according to claim 9,

    wherein the hermetically sealing of the enclosure (1) and/or the cavity (2) is carried out by means of a laser joining process, and/or
    wherein the hermetically sealing of the enclosure (1) and/or cavity (2) is carried out at
    a temperature that is lower or higher than the subsequent operating temperature of the enclosure.

11. Method according to at least one of the preceding method claims, wherein the at least
    two substrates (3, 24, 25) are provided as a wafer stack (9) so that a plurality of hermetically sealed enclosures (1) can be manufactured simultaneously from the wafer stack in a single processing step.

12. Method according to at least one of the preceding method claims, further comprising the step of separating the enclosure (1) from a wafer stack (9), wherein the step is carried out in particular by means of a laser cutting or laser separation step, wherein, in particular, the same laser is used that is also used for the joining step.

13. Use of an enclosure (1) manufactured according to the above method comprising a hermetically sealed housing cavity (2) enclosed therein as a medical implant or as a sensor.

14. Sensor unit and/or medical implant comprising an enclosure (1) according to at least one of claims 1 to 8

**Revendications**

1. Enceinte (1) hermétiquement scellée, comprenant

   au moins un substrat de recouvrement (3) à surface étendue, comportant une face plate (4) extérieure et un chant périphérique,
   et un deuxième substrat (24) disposé de manière adjacente au substrat de recouvrement et étant en contact direct avec le substrat de recouvrement à surface étendue,
   au moins une zone fonctionnelle (2, 18) qui est entourée par l'enceinte et est placée notamment entre le substrat de recouvrement et le deuxième substrat,
   le substrat de recouvrement étant réalisé sous forme de substrat en couche mince transparent, le substrat de recouvrement présentant une épaisseur de moins de 200 μm, **caractérisée en ce que** l'enceinte (1) hermétiquement scellée comporte une ligne de liaison au laser (6, 6a) par laquelle le substrat de recouvrement (3) est directement assemblé de façon hermétiquement étanche avec le deuxième substrat (24) disposé de manière adjacente au substrat de recouvrement.

2. Enceinte (1) hermétiquement scellée selon la revendication précédente, dans laquelle l'épaisseur du substrat de recouvrement (3) est mesurée au niveau du chant périphérique du substrat de recouvrement, et/ou
   dans laquelle le substrat de recouvrement (3) présente une épaisseur de moins de 170 μm, de préférence moins de 150 μm, notamment de préférence moins de 125 μm et/ou présente une épaisseur supérieure à 10 μm, notamment de préférence supérieure à 20 μm.

3. Enceinte (1) hermétiquement scellée selon au moins une des revendications précédentes, présentant au moins une des caractéristiques suivantes :

   - la ligne de liaison au laser présente une largeur W dans une direction parallèle à la dimension d'étendue de surface du substrat de recouvrement, notamment une largeur sur la face plate extérieure du substrat de recouvrement, et

   le substrat de recouvrement présente une résistance au cisaillement accrue, à l'état relié au deuxième substrat ;
   la ligne de liaison au laser (6, 6a) présente une hauteur initiale HL, et le substrat de recouvrement (3) présente moins de la moitié de l'épaisseur, comparée à HL, et/ou
   il est défini :

$$T < D + WH \text{ et/ou } T > CN \text{ ;}$$

   - la face plate (4) extérieure présente au moins une des caractéristiques suivantes :

   une couche de revêtement (16) et/ou
   une nano-impression ou un nano-estampage (16), et/ou
   une zone fonctionnelle (16) ;

   - la face plate (4) extérieure du substrat de recouvrement (3) est **caractérisée en ce qu'**elle est réalisée sous une forme plate, notamment plane, ne comportant en particulier pas de bombements, et présente par ailleurs notamment une déviation maximale par rapport au plan plat qui est inférieure à 5 μm, et présente en outre notamment une valeur de rugosité moyenne Ra inférieure ou égale à 20 nm, et/ou
   le substrat de recouvrement (3) présente dans son ensemble une épaisseur inférieure à 200 μm, et présente notamment une structure plane et possède de manière continue l'épaisseur du chant périphérique ;
   - le substrat de recouvrement (3) forme avec le deuxième substrat (24) un plan de contact ou une zone de contact (10) dans lequel/laquelle le substrat de recouvrement est en contact avec le deuxième substrat, le plan de contact étant exempt de matériaux étrangers, en particulier exempt de matériaux de liaison, tels qu'un adhésif ou une fritte de verre ;
   - le deuxième substrat (24) disposé de manière adjacente est un substrat de base, et

   le substrat de base est assemblé de façon hermétiquement étanche avec le substrat de recouvrement par la même ligne de liaison au laser (6, 6a), ou

le deuxième substrat disposé de manière adjacente est un substrat intermédiaire qui est placé entre le substrat de recouvrement et un substrat de base, le substrat de base est assemblé avec le substrat intermédiaire dans un premier plan de liaison, et le substrat de recouvrement est assemblé avec le substrat intermédiaire dans un deuxième plan de liaison ;

- la ligne de liaison au laser (6, 6a), au nombre d'au moins une, présente une épaisseur WH dans une direction perpendiculaire au sens de l'étendue de surface du substrat de recouvrement (3), et
la ligne de liaison au laser s'étend jusqu'à la face plate (4) extérieure, sachant qu'en particulier la ligne de liaison au laser forme une partie de la face plate extérieure ;
- dans la région de la ligne de liaison au laser (6, 6a), il existe une modification de matériau du substrat de recouvrement (3) et/ou du deuxième substrat (24) adjacent, en particulier une

modification de l'indice de réfraction et/ou une composition chimique modifiée, et cette modification de matériau forme une zone de la face plate (4) extérieure.

4. Enceinte (1) hermétiquement scellée selon la revendication 3,

dans laquelle la largeur W de la ligne de liaison au laser (6, 6a) est supérieure à l'épaisseur D du substrat de recouvrement (3), et/ou
dans laquelle la largeur W de la ligne de liaison au laser (6, 6a) présente un rapport avec l'épaisseur D du substrat de recouvrement (3), tel que W/D supérieur ou égal à 1, notamment W/D supérieure ou égal à 0,05.

5. Enceinte (1) hermétiquement scellée selon au moins une des revendications précédentes, dans laquelle la zone fonctionnelle (2, 18) comporte une cavité d'accueil destinée à accueillir un objet à loger (5), par exemple un circuit électronique, un capteur ou un MEMS.

6. Enceinte (1) hermétiquement scellée selon au moins une des revendications précédentes, dans laquelle le substrat de recouvrement (3) est transparent pour une gamme de longueurs d'ondes, au moins en partie et/ou au moins par zones.

7. Enceinte (1) hermétiquement scellée selon au moins une des revendications précédentes, dans laquelle le substrat de recouvrement (3) est constitué de verre, vitrocéramique, silicium, saphir ou d'une combinaison des matériaux précités, ou dans laquelle le substrat de recouvrement est en matériau céramique, et comporte notamment un matériau en céramique oxydée.

8. Enceinte (1) hermétiquement scellée selon une des revendications 1 à 7,
dans laquelle la ligne de liaison au laser (6, 6a) s'étend jusqu'à la face plate (4) extérieure, sachant qu'en particulier la ligne de liaison au laser (6, 6a) forme une partie de la face plate (4) extérieure.

9. Procédé de mise à disposition d'une enceinte (1) hermétiquement scellée, selon lequel l'enceinte renferme une zone fonctionnelle (2, 18), la zone fonctionnelle étant notamment réalisée sous forme de cavité d'accueil (2) destinée à accueillir au moins un objet à loger (5), comprenant les étapes suivantes :

- mise à disposition d'au moins un substrat de recouvrement (3) et d'un deuxième substrat (24),

le substrat de recouvrement comportant un matériau transparent,
les substrats, au nombre d'au moins deux, étant disposés directement l'un contre l'autre ou l'un sur l'autre, de sorte qu'une zone de contact (10) est formée entre les substrats, au nombre d'au moins deux, et
selon lequel le substrat de recouvrement présente une face plate (4) extérieure et un chant périphérique,

- scellement hermétiquement étanche de l'enceinte, par assemblage direct des substrats, au nombre d'au moins deux, le long de la zone de contact, au nombre d'au moins une, de l'enceinte, au moyen d'une ligne de liaison au laser (6, 6a),
- enlèvement de matière du substrat de recouvrement, notamment enlèvement par abrasion, par exemple par meulage, et ainsi, réalisation d'un substrat en couche mince à partir du substrat de recouvrement (3), le chant périphérique recevant de ce fait une épaisseur de moins de 200 $\mu$m.

10. Procédé selon la revendication 9,

selon lequel le scellement hermétiquement étanche de l'enceinte (1) et/ou de la cavité (2) est réalisé au moyen d'un procédé d'assemblage au laser, et/ou

selon lequel le scellement hermétiquement étanche de l'enceinte (1) et/ou de la cavité (2) est réalisé à une température qui est inférieure ou supérieure à la température d'utilisation ultérieure de l'enceinte.

11. Procédé selon au moins une des revendications de procédé précédentes, selon lequel les substrats (3, 24, 25), au nombre d'au moins deux, sont mis à disposition sous forme de pile de tranches (9), en vue de fabriquer, à partir de la pile de tranches, une pluralité d'enceintes (1) hermétiquement scellées, conjointement au cours du même processus de travail.

12. Procédé selon au moins une des revendications de procédé précédentes, comprenant en outre l'étape de prélèvement individuel de l'enceinte (1) dans une pile de tranches (9), l'étape étant exécutée notamment au moyen d'une étape de coupe au laser ou de sectionnement au laser, où l'on utilise en outre notamment le même laser que celui servant à l'étape d'assemblage.

13. Utilisation d'une enceinte (1) fabriquée selon le procédé ci-dessus, avec une cavité d'accueil (2) hermétiquement scellée, enfermée dans l'enceinte, en tant qu'implant médical ou en tant que capteur.

14. Unité de capteur et/ou implant médical, comportant une enceinte (1) selon au moins une des revendications 1 à 8.

Fig. 1

Fig. 2a

Fig. 2b

Fig. 3

110

5    5    5    5    7

9

24    2    2    2    1

120

6  5   6  6  5   6  6  5   6    7

9

24    2    2    2    1

130

6a   6a   6a   4    3

9

24    1

140

20

3

9

1

150

16   22   16   22   16

1    1    1

Fig. 4a

Fig. 4b

Fig. 5

Fig. 6

Fig. 7a

Fig. 7b

Fig. 7c

Fig. 7d

Fig. 8

Fig. 9

Fig. 10a

Fig. 10b

Fig. 11

Fig. 12

Draufsicht

45

48

2

y

x

4

1

Fig. 13

Schnittansicht

3  6a  3a  48  6a  2

24

25

52

1

Fig. 14

Seitenansicht

3  6a  6a

24

25

1

Fig. 15

45

48

Minimale
Auskragung

f(u)

2

c

4

1

Fig. 16

Fig. 17

Fig. 18

Fig. 19

## Vor dem Polieren — <u>Fig. 20</u>

1
6
7

## Nach dem Polieren — <u>Fig. 21</u>

1
6a
3

Vor dem Polieren  Fig. 22

Fig. 23

Nach dem Polieren

**EP 4 172 103 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3012059 B1
- EP 2219215 A1